# FASCICULE DE BREVET EUROPEEN

(11) **EP 4 092 750 B1**
(45) Date de publication et mention de la délivrance du brevet: **11.10.2023**
(21) Numéro de dépôt: 22174169.7
(22) Date de dépôt: 18.05.2022
(51) Int. Cl.: H10B 63/00

(54) **MEMOIRE 1T1R A STRUCTURE 3D**
1T1R-SPEICHER MIT 3D-STRUKTUR
1T1R MEMORY WITH 3D STRUCTURE

(30) Priorité: 20.05.2021 FR 2105264
(43) Date de publication de la demande: 23.11.2022
(73) Titulaire: Commissariat à l'énergie atomique et aux énergies alternatives, 75015 Paris (FR)
(72) Inventeur: BARRAUD, Sylvain, 38054 GRENOBLE CEDEX 09 (FR); ANDRIEU, François, 38054 GRENOBLE CEDEX 09 (FR)
(74) Mandataire: Brevalex

(56) Documents cités:
- US-A1- 2017 047 376
- US-A1- 2017 092 541
- US-B1- 8 026 521

## Description

### DOMAINE TECHNIQUE

L'invention concerne le domaine des mémoires, notamment celui des mémoires RAM non volatiles, ou NVRAM pour « Non-Volatile Random-Access Memory » en anglais, de type 1T1R (c'est-à-dire dans lesquelles chaque élément mémoire, ou point mémoire, est couplé à un transistor d'accès) et à une structure 3D (c'est-à-dire comportant plusieurs niveaux superposés dans chacun desquels se trouve une matrice d'éléments mémoires).

### ÉTAT DE LA TECHNIQUE ANTÉRIEURE

Dans le domaine des mémoires, il existe un besoin de trouver un compromis entre capacité de stockage, vitesse et coût. Les mémoires de type HDD (« Hard Disk Drive » en anglais) et SSD (« Solid-State Drive » en anglais) offrent des capacités de stockage importantes pour un coût raisonnable, mais une faible vitesse de fonctionnement. A l'inverse, les mémoires volatiles de type DRAM (« Dynamic Random Access Memory » en anglais) ou SRAM (« Static Random Access Memory » en anglais) permettent d'atteindre des vitesses de fonctionnement bien plus importantes, mais les capacités de stockage sont faibles.

A mi-chemin entre ces deux types de mémoire se trouvent les mémoires de type SCM, ou « Storage Class Memory » en anglais. Ce type de mémoire englobe différentes technologies, et notamment des mémoires NVRAM comme par exemple les mémoires de type RRAM ou « Resistive Random-Access Memory » en anglais, MRAM ou « Magnetoresistive Random-Access Memory » en anglais, PCRAM ou « Phase-Change Random-Access Memory » ou bien encore Fe-RAM ou « Ferroelectric Random-Access Memory ». Avec ce type de mémoire, il est envisagé de proposer des solutions de densités plus importantes que les mémoires DRAM actuelles tout en étant plus rapides et moins chères que les mémoires FLASH NAND.

Une structure classique de mémoire NVRAM est l'architecture dite « Crossbar » dans laquelle une matrice d'éléments mémoires est pilotée par un réseau de lignes de bit, de source et de mot, les lignes de mot étant orientées perpendiculairement aux lignes de bit et aux lignes de source. Dans une telle structure, chaque élément mémoire peut être couplé à un transistor d'accès (structure 1T1R) pour éviter les courants de fuite entre les éléments mémoires ainsi que les interférences entre eux. Les transistors d'accès sont toutefois encombrants et limitent la densité maximum atteignable d'éléments mémoires dans un volume donné.

Le document US 2017/0092541 A1 décrit une mémoire NVRAM à structure 3D et comprenant des nanofils semi-conducteurs empilés pour former des transistors d'accès sans jonction. Dans la structure proposée dans ce document, les grilles des transistors ne sont pas en contact direct sur les zones actives qui représentent les régions SL (« sourceline »), ce qui limite la densité atteignable d'éléments mémoires car la distance entre les grilles et les zones actives doit être suffisamment grande pour permettre la gravure de ces grilles. En outre, du fait que les grilles ne recouvrent que deux côtés de chaque nanofil, un faible niveau de courant par nanofil est obtenu pour venir écrire les éléments mémoires, ainsi qu'un faible niveau de contrôle électrostatique des transistors (donc des plus forts courants de fuite sont attendus lorsque le transistor sera dans un état passant). De plus, les grilles sont communes à tous les nanofils empilés, ce qui implique de réaliser une reprise de contact séparée entre les différents niveaux de fil dans la région SL. Une telle reprise de contact entraîne souvent de grandes longueurs de ligne, et donc de fortes résistances d'accès qui risquent de réduire fortement le courant délivré par le transistor, ce qui peut empêcher une écriture dans le point mémoire. En outre, les lignes de source sont réalisées au sein de l'empilement servant à la réalisation des transistors, avant la gravure des grilles, ce qui implique que les distances entre ces lignes doivent être assez grandes pour pouvoir disposer deux grilles de transistors entre deux lignes SL consécutives. Les règles de dessin fixant la distance minimale entre la grille et la zone active sont un frein à l'obtention d'un design régulier et dense. Enfin, les lignes de source sont en silicium dopé, donc très résistives et contribuant aux inconvénients précédemment décrits.

Le document US 2014/0054538 A1 décrit une mémoire NVRAM à structure 3D et comprenant des nanofils semi-conducteurs empilés pour former des transistors d'accès de type TFET (tunnel-FET). Là encore, les grilles ne recouvrent que deux côtés de chaque nanofil semi-conducteur, ce qui engendre une perte de la largeur effective et donc une perte de courant par unité de surface. En outre, les nanofils semi-conducteurs superposés sont connectés ensemble du côté source des transistors. L'empilement réalisé ne bénéficie donc pas à l'augmentation du nombre total d'éléments mémoires. De plus, les régions dans lesquelles sont formés les éléments mémoires sont réalisées avant les grilles de contrôle des transistors qui joueront le rôle de sélecteur d'élément mémoire. Pour des raisons de désalignement lié à la lithographie, les distances entre les éléments mémoires et les grilles ne sont pas toujours les mêmes, ce qui pose un problème de variabilité et d'irrégularité de design.

Le document US 2009/0218558 A1 décrit une mémoire NVRAM à structure 3D et comprenant des transistors empilés. Dans cette mémoire, la structure planaire des grilles des transistors nécessite d'avoir des grilles assez longues pour avoir un bon contrôle électrostatique des transistors, ce qui est une contrainte pour la densité d'éléments mémoires atteignable. En outre, du fait que la réalisation de cette mémoire est basée sur une intégration 3D monolithique, les transistors sont réalisés séparément entre chaque niveau, et l'auto-alignement des structures empilées n'est pas garanti. Cela peut être problématique pour l'obtention d'un design régulier de la mémoire. La densité en est également affectée. Le document US8026521 B1 décrit une mémoire. Le dispositif comporte deux couches transférées de silicium monocristallin, l'une des couches transférées de silicium monocristallin comportant un ensemble de transistors orientés horizontalement. L'autre couche transférée de silicium monocristallin comprend un autre jeu de transistors orientés horizontalement, ce dernier jeu de transistors orientés horizontalement recouvrant le premier jeu de transistors orientés horizontalement. Un ensemble de lignes de contrôle des cellules de mémoire est incorporé dans la première couche transférée de silicium monocristallin et dans la seconde couche transférée de silicium monocristallin.

Le document US2017092541 A1 divulgue un dispositif semi-conducteur 3D comprenant : une première structure comprenant des premiers transistors monocristallins ; une seconde structure comprenant des seconds transistors monocristallins, la seconde structure recouvrant les premiers transistors monocristallins, où au moins l'un des seconds transistors monocristallins est au moins partiellement auto-aligné sur au moins l'un des premiers transistors monocristallins ; et au moins une voie de conduction thermique entre au moins l'un des premiers transistors monocristallins et des seconds transistors monocristallins et une surface externe du dispositif.
D'autres mémoires NVRAM à structure 3D et à nanofils semi-conducteurs empilés ont été proposées. Lorsque ces structures comportent de longues lignes de bits semi-conductrices ou métalliques formées au sein du même empilement que celui servant à la réalisation des nanofils semi-conducteurs, ces lignes sont très résistives, ce qui pose un problème pour obtenir un même courant d'attaque pour tous les transistors.

### EXPOSÉ DE L'INVENTION

Un but de la présente invention est de proposer une mémoire, par exemple de type NVRAM, à structure 3D ne présentant pas les inconvénients des mémoires de l'art antérieur précédemment décrites.

Pour cela, la présente invention propose une mémoire comportant une structure en lignes et colonnes sur plusieurs niveaux mémoires superposés, chaque niveau mémoire comprenant au moins une matrice d'éléments mémoires et de transistors d'accès à grille enrobante, chaque transistor d'accès comportant un nanofil semi-conducteur dont au moins une partie est enrobée par une grille, chaque grille étant isolée électriquement vis-à-vis des grilles des transistors d'accès des autres niveaux mémoires, la mémoire comprenant :
- des premières portions électriquement conductrices, chacune traversant au moins deux niveaux mémoires et étant couplée électriquement à des premières extrémités des nanofils semi-conducteurs de transistors d'accès appartenant à au moins une colonne et une ligne de chacun desdits au moins deux niveaux mémoires ;
- des empilements mémoires, chacun traversant lesdits au moins deux niveaux mémoires et formant des éléments mémoires appartenant à au moins une colonne et une ligne de chacun desdits au moins deux niveaux mémoires, chaque empilement mémoire comprenant au moins une couche de matériau mémoire disposée entre au moins une deuxième portion électriquement conductrice formant une première électrode desdits éléments mémoires et au moins une couche électriquement conductrice formant une deuxième électrode desdits éléments mémoires, la couche électriquement conductrice étant disposée contre des deuxièmes extrémités des nanofils semi-conducteurs desdits transistors d'accès ;
- des premières lignes électriquement conductrices, chacune étant reliée électriquement aux premières portions électriquement conductrices d'une même colonne de la mémoire ;
- des deuxièmes lignes électriquement conductrices, chacune étant reliée électriquement aux deuxièmes portions électriquement conductrices d'une même colonne de la mémoire ;
- des lignes de mot s'étendant chacune dans un même niveau mémoire correspondant à un desdits au moins deux niveaux mémoires en couplant électriquement entre elles les grilles des transistors d'accès d'une même ligne de la mémoire et localisés dans ledit niveau mémoire.

Cette mémoire fait appel à des transistors à grille enrobante, ou GAA (« Gate All-Around » en anglais), ce qui est favorable à l'obtention de forte densité d'éléments mémoire au sein de la mémoire, d'un important niveau de contrôle électrostatique des transistors ainsi que de forts courant de sortie pour alimenter les éléments mémoires. Une grille enrobante correspond à une grille entourant, ou recouvrant, tous les côtés du nanofil au moins au niveau de la région de canal du transistor. Dans le cas d'un nanofil de section rectangulaire, une grille enrobante recouvre les 4 côtés, ou faces latérales, du nanofil.

Dans cette mémoire, du fait que les grilles des transistors sont isolées électriquement entre elles d'un niveau à l'autre, les transistors sont commandables indépendamment pour chaque niveau mémoire, ce qui permet un adressage indépendant des éléments mémoires de chaque niveau mémoire.

Dans cette structure, les premières et deuxièmes lignes électriquement conductrices, destinées à former les lignes de source et de bit des matrices d'éléments mémoires, ne sont pas réalisées au sein des niveaux mémoires, ne créant ainsi pas de contrainte sur les règles de dessin applicable à cette mémoire et évitant d'avoir à réaliser des lignes de source ou de bit très résistives.

Dans cette mémoire, chacune des lignes de source et des lignes de bits, formées par les premières et deuxièmes lignes électriquement conductrices, est commune à tous les niveaux mémoires et à tous les éléments mémoires et transistors d'accès d'une même colonne de la mémoire. Par contre, les lignes de mots, commandant les transistors d'accès, sont indépendantes pour chaque niveau mémoire et pour les différentes lignes de la mémoire.

Dans l'ensemble du document, le terme « sur » est utilisé sans distinction de l'orientation dans l'espace de l'élément auquel se rapporte ce terme. Par exemple, dans la caractéristique « sur une face », cette face n'est pas nécessairement orientée vers le haut mais peut correspondre à une face orientée selon n'importe quelle direction. En outre, la disposition d'un premier élément sur un deuxième élément doit être comprise comme pouvant correspondre à la disposition du premier élément directement contre le deuxième élément, sans aucun élément intermédiaire entre les premier et deuxième éléments, ou bien comme pouvant correspondre à la disposition du premier élément sur le deuxième élément avec un ou plusieurs éléments intermédiaires disposés entre les premier et deuxième éléments.

Dans tout le document, les termes « ligne » et « colonne » ont été choisis de manière arbitraire. Dans un plan, le terme « ligne » est généralement associé à une disposition horizontale et le terme « colonne » est généralement associé à une disposition verticale. Ces termes ne doivent toutefois pas être interprétés uniquement selon cette disposition, mais comme désignant, dans un plan, deux orientations différentes, généralement sensiblement perpendiculaires l'une par rapport à l'autre. Par exemple, le terme « ligne » peut être associé, dans un plan, à une disposition verticale, et le terme « colonne » peut être associé à une disposition horizontale.

Dans tout le document, le terme « nanofil » est utilisé pour désigner un élément conducteur d'épaisseur inférieure à environ 20 nm, et dont la largeur peut être égale ou supérieure à cette épaisseur. Dans tout le document, le terme « nanofil » doit être compris comme pouvant être synonyme du terme « nano-feuille » ou « nanosheet » en anglais.

Le terme « empilement » désigne une succession de plusieurs éléments selon une ou plusieurs directions.

Le couplage électrique entre les premières portions électriquement conductrices et les premières extrémités des nanofils semi-conducteurs peut correspondre à un contact métal - semi-conducteur entre les premières portions électriquement conductrices et les premières extrémités des nanofils semi-conducteurs.

La mémoire peut correspondre à une mémoire NVRAM.

Les nanofils semi-conducteurs des transistors d'accès peuvent comporter du silicium polycristallin ou monocristallin, ou de l'oxyde métallique (In₂O₃ par exemple) ou au moins un matériau 2D semi-conducteur (par exemple du dichalcogénure de métaux de transition tel que du MoS₂, WSe₂). L'expression « matériau 2D », ou matériau bidimensionnel, désigne un matériau constitué d'un feuillet, ou d'un empilement de feuillets, de quelques atomes d'épaisseur, typiquement de 10 atomes maximum. Un matériau 2D est saturé électroniquement, et un empilement de plusieurs feuillets est obtenu grâce à des liaisons de Van der Waals entre les couches d'atomes. Parmi les matériaux 2D, certains sont semi-conducteurs. Leur très faible épaisseur donne naissance à des propriétés électroniques, optoélectroniques et mécaniques singulières.

Le matériau mémoire peut correspondre à un matériau résistif ou magnéto-résistif ou à changement de phase ou ferroélectrique.

Dans la mémoire, le nombre de niveaux mémoires peut être compris entre deux et cent, et de préférence supérieur ou égal à trois.

Chacune des lignes de mot d'une ligne de la mémoire peut être isolée électriquement des autres lignes de mot appartenant à ladite ligne de la mémoire. Autrement dit, dans une ligne de la mémoire, les lignes de mot réparties dans les différents niveaux mémoires sont isolées électriquement les unes des autres.

Dans ce cas, la mémoire peut comporter en outre, dans chaque ligne de la mémoire, des contacts électriques de grille chacun couplé électriquement à une des lignes de mot d'un des niveaux mémoires, localisés à une extrémité de ladite ligne de la mémoire et isolés électriquement les uns vis-à-vis des autres.

Chacune des lignes de mot d'une des lignes de la mémoire peut être isolée électriquement des lignes de mot appartenant aux autres lignes de la mémoire.

Les premières et deuxièmes lignes électriquement conductrices peuvent faire partie de niveaux métalliques d'interconnexions distincts des niveaux mémoires.

La mémoire peut comporter en outre des portions diélectriques d'isolation interposées entre des grilles superposées et disposées dans deux niveaux mémoires voisins.

La mémoire peut comporter des éléments diélectriques d'isolation traversant tous les niveaux mémoires et séparant chacun deux lignes voisines de la mémoire.

Dans une configuration avantageuse :
- chacune des premières portions électriquement conductrices peut traverser tous les niveaux mémoires et être couplée électriquement aux premières extrémités des nanofils semi-conducteurs de transistors d'accès de chacun des niveaux mémoires ;
- chacun des empilements mémoires traverse tous les niveaux mémoires et forme des éléments mémoires de chacun des niveaux mémoires ;
- les lignes de mot s'étendent dans chacun des niveaux mémoires.

L'invention concerne également un procédé de réalisation d'une mémoire comportant au moins :
- réalisation d'un empilement de premières, deuxièmes et troisièmes couches, chaque deuxième couche étant disposée entre deux troisièmes couches et en contact avec ces deux troisièmes couches, et chaque troisième couche étant en contact avec une des premières couches, les premières couches comportant un matériau semi-conducteur, les deuxièmes couches comportant un matériau pouvant être gravé sélectivement vis-à-vis des matériaux des premières et troisièmes couches, et les troisièmes couches comportant un matériau pouvant être gravé sélectivement vis-à-vis des matériaux des premières et deuxièmes couches ;
- gravure de premières cavités à travers au moins une partie de l'épaisseur de l'empilement, alignées en formant des lignes et des colonnes ;
- gravure de parties des deuxièmes couches localisées entre les premières cavités d'une même ligne ;
- réalisation de portions diélectriques d'isolation dans des espaces formés par la gravure desdites parties des deuxièmes couches, et configurées pour assurer une isolation électrique entre différents niveaux mémoires ;
- gravure de tranchées à travers toute l'épaisseur de l'empilement, séparant et isolant des parties de l'empilement comportant chacune une ligne de premières cavités ;
- gravure partielle des premières couches depuis les tranchées, telle que des portions restantes des premières couches de semi-conducteur localisées entre les premières cavités forment des nanofils semi-conducteurs ;
- gravure des troisièmes couches de l'empilement ;
- dépôt d'au moins un diélectrique de grille et d'au moins un matériau conducteur de grille dans des espaces formés par la gravure des troisièmes couches de l'empilement, formant une grille enrobante autour d'au moins une partie de chacun des nanofils semi-conducteurs et des lignes de mot s'étendant chacune dans un même niveau mémoire correspondant à un des niveaux mémoires en couplant électriquement entre elles les grilles d'une même ligne et localisées dans ledit un des niveaux mémoires ;
- dépôt d'un matériau diélectrique dans les tranchées ;
- réalisation de premières portions électriquement conductrices dans une partie des premières cavités telles que chacune traverse au moins deux niveaux mémoires et soit couplée électriquement à des premières extrémités des nanofils semi-conducteurs au niveau d'au moins une face latérale de ladite première portion électriquement conductrice ;
- réalisation d'empilement mémoires dans les autres premières cavités, chacun traversant lesdits au moins deux niveaux mémoires et comprenant au moins une couche de matériau mémoire disposée entre au moins une deuxième portion électriquement conductrice et au moins une couche électriquement conductrice disposée contre des deuxièmes extrémités des nanofils semi-conducteurs ;
- réalisation de premières lignes électriquement conductrices telles que chacune soit reliée électriquement aux premières portions électriquement conductrices d'une même colonne de la mémoire, et réalisation de deuxièmes lignes électriquement conductrices telles que chacune soit reliée électriquement aux deuxièmes portions électriquement conductrices d'une même colonne de la mémoire.

De manière avantageuse, le procédé peut être tel que :
- les premières couches comportent du silicium,
- les deuxièmes et troisièmes couches comportent du SiGe, et
- le taux de germanium dans le SiGe des deuxièmes couches est différent du taux de germanium dans le SiGe des troisièmes couches.

Le procédé peut comporter en outre, entre la réalisation des portions diélectriques d'isolation et la gravure des tranchées, une gravure partielle des troisièmes couches de l'empilement depuis des parois latérales des premiers emplacements, puis une réalisation d'espaceurs diélectriques internes dans des espaces formés par la gravure partielles des troisièmes couches.

Le procédé peut comporter en outre, entre la réalisation des portions diélectriques d'isolation et la gravure des tranchées, un dépôt d'un matériau sacrificiel dans les premières cavités, ce matériau sacrificiel étant supprimé avant la réalisation des premières et deuxièmes portions électriquement conductrices.

L'étape de gravure des premières cavités peut former également des deuxièmes cavités à travers toute l'épaisseur de l'empilement et chacune localisée à une extrémité d'une ligne de premières cavités, et le procédé peut comporter une étape de réalisation de contacts électriques de grille dans les deuxièmes cavités, chacun couplé électriquement à une ligne de mot d'un des niveaux mémoires et isolés électriquement les uns vis-à-vis des autres.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- la figure 1 représente un schéma électrique d'une mémoire, objet de la présente invention, selon un mode de réalisation particulier ;
- la figure 2 représente schématiquement un exemple de réalisation d'une mémoire, objet de la présente invention, selon un mode de réalisation particulier;
- les figures 3 à 27 représentent les étapes d'un procédé de réalisation d'une mémoire, objet de la présente invention, selon un mode de réalisation particulier;
- les figures 28 à 37 représentent les étapes d'un procédé de réalisation d'une mémoire, objet de la présente invention, selon une variante de réalisation.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

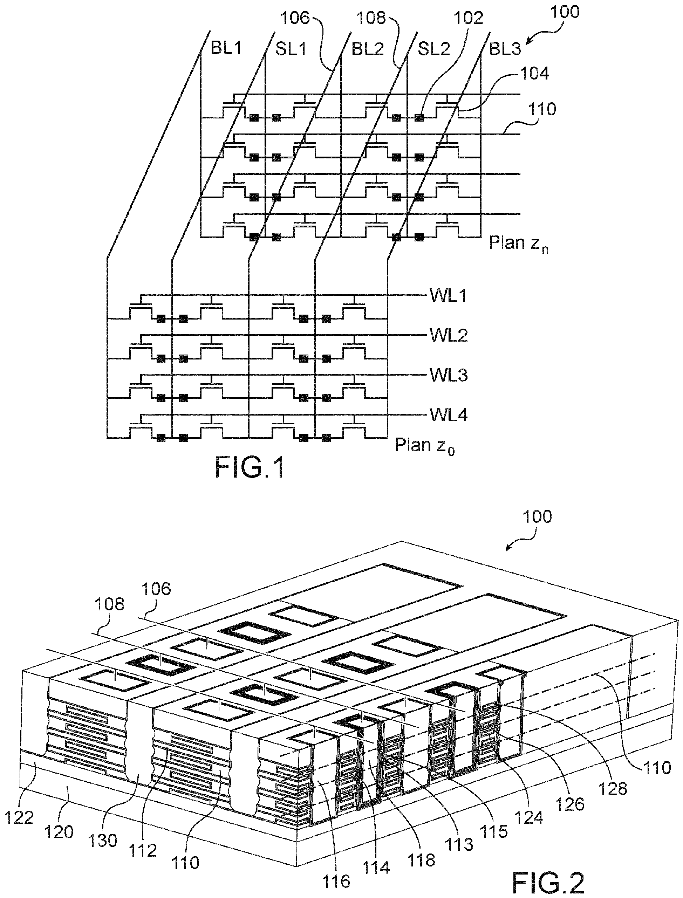

Une mémoire 100, par exemple NVRAM, selon un mode de réalisation particulier est décrite ci-dessous en lien avec les figures 1 et 2. La figure 1 représente un schéma électrique de la mémoire 100 dans ce mode de réalisation particulier, et la figure 2 représente schématiquement un exemple de réalisation de la mémoire 100 dans ce mode de réalisation particulier.

La mémoire 100 est réalisée sous la forme d'une structure 3D agencée en lignes et en colonnes, et comprenant plusieurs niveaux mémoires superposés (quatre dans l'exemple décrit ici). La mémoire 100 comporte plusieurs matrices d'éléments mémoires 102 et de transistors d'accès 104 à grille enrobante superposées les unes au-dessus des autres, chacune agencée dans un des niveaux mémoires. Dans chacune de ces matrices, chaque élément mémoire 102 est couplé électriquement à un transistor d'accès 104 associé uniquement à cet élément mémoire 102.

Afin de faciliter la description de la mémoire 100, l'expression « ligne 3D » d'éléments mémoires 102 ou de transistors d'accès 104 est utilisée pour désigner l'ensemble des éléments mémoires 102 ou des transistors d'accès 104 d'une ligne de chacune des matrices de la mémoire 100 et qui sont superposées les unes au-dessus des autres. De même, l'expression « colonne 3D » d'éléments mémoires 102 ou de transistors d'accès 104 est utilisée pour désigner l'ensemble des éléments mémoires 102 ou des transistors d'accès 104 d'une colonne de chacune des matrices de la mémoire 100 et qui sont superposées les unes au-dessus des autres.

La mémoire 100 comporte des premières lignes électriquement conductrices 106 et des deuxièmes lignes électriquement conductrices 108 formant respectivement, dans le mode de réalisation décrit ici, des lignes de bit et des lignes de source. En variante, les premières et deuxièmes lignes électriquement conductrices 106, 108 pourraient former respectivement les lignes de source et les lignes de bit de la mémoire 100. Chacune des premières et deuxièmes lignes électriquement conductrices 106, 108 est commune à tous les niveaux mémoires et à tous les éléments mémoires 102 et transistors d'accès 104 d'une même colonne de la mémoire 100. Les premières et deuxièmes lignes électriquement conductrices 106, 108 sont par exemple réalisées dans des niveaux métalliques d'interconnexions distincts des niveaux mémoires.

Plus particulièrement, dans le mode de réalisation décrit ici, chacune des premières lignes électriquement conductrices 106 est couplée à une première électrode de source ou de drain de chacun des transistors d'accès 104 de deux colonnes 3D de transistors d'accès 104 voisines l'une de l'autre (excepté pour les premières lignes électriquement conductrices 106 se trouvant au bord de la mémoire 100 qui sont chacune couplée à une première électrode de source ou de drain de chacun des transistors d'accès 104 d'une seule colonne 3D de transistors d'accès 104). De plus, chacune des deuxièmes lignes électriquement conductrices 108 est couplée à une première électrode de chacun des éléments mémoires 102 de deux colonnes 3D d'éléments mémoires 102 voisines l'une de l'autre.

Une deuxième électrode de chacun des éléments mémoires 102 est couplée électriquement à une deuxième électrode de source ou de drain du transistor d'accès 104 qui lui est associé.

Enfin, la mémoire 100 comporte des lignes de mot 110 qui ne sont pas communes à tous les niveaux mémoires, mais qui sont chacune associée à un seul niveau mémoire. Chacune des lignes de mot 110 relie électriquement des grilles des transistors d'accès 104 d'une ligne d'un seul niveau mémoire. Sur la figure 2, quatre lignes de mot appartenant à une ligne 3D de la mémoire 100 et répartis dans tous les niveaux mémoires sont représentées par des pointillés.

En outre, dans la mémoire 100, les transistors d'accès 104 sont de type GAA et les grilles de deux transistors superposés l'un au-dessus de l'autre et disposés dans deux niveaux mémoires voisins de la mémoire 100 sont isolées électriquement l'une de l'autre par des portions diélectriques d'isolation 112. Chacun des transistors d'accès 104 comporte un nanofil semi-conducteur 114 dont au moins une partie formant le canal du transistor d'accès 104 est enrobée par sa grille. Le semi-conducteur des nanofils 114 correspond par exemple à du silicium polycristallin ou monocristallin, ou de l'oxyde métallique comme par exemple de l'In₂O₃, ou au moins un matériau 2D comme par exemple du dichalcogénure de métaux de transition tel que du MoS₂ ou du WSe₂.

La mémoire 100 comporte par exemple un nombre de niveaux mémoires compris entre 2 et quelques dizaines (100), et avantageusement supérieur ou égal à 3.

La longueur de chaque nanofil 114 (dimension selon l'axe Y sur la figure 2) est par exemple comprise entre 30 nm et 250 nm. La largeur de chaque nanofil 114 (dimension selon l'axe X sur la figure 2) est par exemple comprise entre 10 nm et 150 nm. La hauteur de chaque nanofil 114 (dimension selon l'axe Z sur la figure 2) est par exemple comprise entre 8 nm et 30 nm.

La mémoire 100 comporte des premières portions électriquement conductrices 116, chacune traversant tous les niveaux de la mémoire 100. Chacune des premières portions électriquement conductrices 116 est couplée électriquement à des premières extrémités des nanofils 114 des transistors d'accès 104 appartenant à deux colonnes 3D voisines de la mémoire 100 (sauf celles se trouvant sur un des bords de la mémoire 100 qui sont couplées électriquement à des premières extrémités des nanofils 114 des transistors d'accès 104 appartenant à une seule colonne 3D de la mémoire 100). Chacune des premières portions électriquement conductrices 116 forme les premières électrodes de source ou de drain des transistors d'accès 104 (électrodes de source dans l'exemple décrit ici) dont les premières extrémités des nanofils 114 sont couplées électriquement à cette première portion électriquement conductrice 116. Dans l'exemple de réalisation décrit ici, chaque première portion électriquement conductrice 116 est formée par un empilement de Ti, TiN et W.

Dans la mémoire 100, les éléments mémoires 102 sont réalisés sous la forme d'empilements mémoires, chacun traversant tous les niveaux de la mémoire 100. Chaque empilement mémoire forme des éléments mémoires répartis dans tous les niveaux mémoires et appartenant à une ligne 3D et à deux colonnes 3D voisines de la mémoire 100 (sauf ceux se trouvant sur un des bords de la mémoire 100 qui forment des éléments mémoires 102 appartenant à une seule colonne 3D de la mémoire 100).

Chaque empilement mémoire comporte au moins une couche de matériau mémoire 115 de type résistif (cas d'une mémoire 100 de type RRAM), ou magnéto-résistif (cas d'une mémoire 100 de type MRAM), ou à changement de phase (cas d'une mémoire 100 de type PCRAM), ou bien ferroélectrique (cas d'une mémoire 100 de type F-RAM et dans une configuration 1T1C). Dans l'exemple de réalisation décrit ici, la couche de matériau mémoire 115 comporte du HfO₂, ferromagnétique ou non, et une épaisseur par exemple comprise entre 3 nm et 10 nm.

La couche de matériau mémoire 115 est disposée entre une deuxième portion électriquement conductrice 118 formant une première électrode des éléments mémoires 102 et une couche électriquement conductrice 113 formant une deuxième électrode des éléments mémoires 102 et à laquelle sont couplés des deuxièmes extrémités des nanofils 114 des transistors d'accès 104 appartenant à la ou aux colonnes 3D qui incluent ces éléments mémoires 102. La couche électriquement conductrice 113 comporte par exemple du TiN ou du siliciure (par exemple du NiPtSi) ou du Si:P (silicium fortement dopé). La deuxième portion électriquement conductrice 118 comporte par exemple une couche de Ti et une couche de TiN, et éventuellement en plus une couche de W.

Les éléments formant la structure 3D de la mémoire 100 sont disposés sur un substrat. Sur l'exemple de réalisation de la figure 2, le substrat correspond à un substrat SOI comprenant une couche support 120, par exemple à base de silicium, une couche diélectrique enterrée 122 disposée entre la couche support 120 et les nanofils 114 du premier niveau mémoire de la mémoire 100 et comprenant par exemple du SiO₂, et une couche superficielle de semi-conducteur ayant servie à la réalisation des nanofils 114 du premier niveau mémoire de la mémoire 100. Les éléments formant la structure 3D de la mémoire 100 pourraient aussi être réalisés sur un substrat massif, par exemple de silicium.

Les grilles des transistors d'accès 104 comporte au moins un matériau diélectrique de grille 124 recouvrant les parties des nanofils 114 formant les canaux des transistors d'accès 104, et au moins un matériau conducteur de grille 126 recouvrant le matériau diélectrique de grille 124. Dans l'exemple de réalisation décrit ici, le matériau diélectrique de grille 124 correspond à une couche de HfO₂ dont l'épaisseur est égale à 2 nm, et le matériau conducteur de grille 126 correspond à une couche de TiN dont l'épaisseur est égale à 10 nm.

Chacun des transistors d'accès 104 comporte également des espaceurs internes 128 disposés entre la grille et les première et deuxième portions électriquement conductrices 116, 118 formant les électrodes de source et de drain de ce transistor. Dans l'exemple de réalisation décrit ici, les espaceurs internes 128 comportent du SiN.

Les grilles et les lignes de mot 110 de chaque ligne 3D de la mémoire 100 sont isolées électriquement des grilles et des lignes de mot 110 des lignes 3D voisines par des éléments diélectriques d'isolation 130 traversant tous les niveaux de la mémoire 100, s'étendant parallèlement aux lignes 3D de la mémoire 100 et séparant deux lignes voisines de la mémoire 100.

La mémoire 100 comporte également des contacts électriques de grille chacun couplé électriquement à une ligne de mot 110 d'un des niveaux mémoires. Afin de pouvoir accéder aux lignes de mot 110 des différents niveaux de la mémoire 100, les contacts électriques des lignes de mots 110 de chaque ligne 3D de la mémoire 100 sont isolés électriquement les uns des autres et disposés selon un agencement dit « en escalier » situés en périphérie du coeur de la matrice.

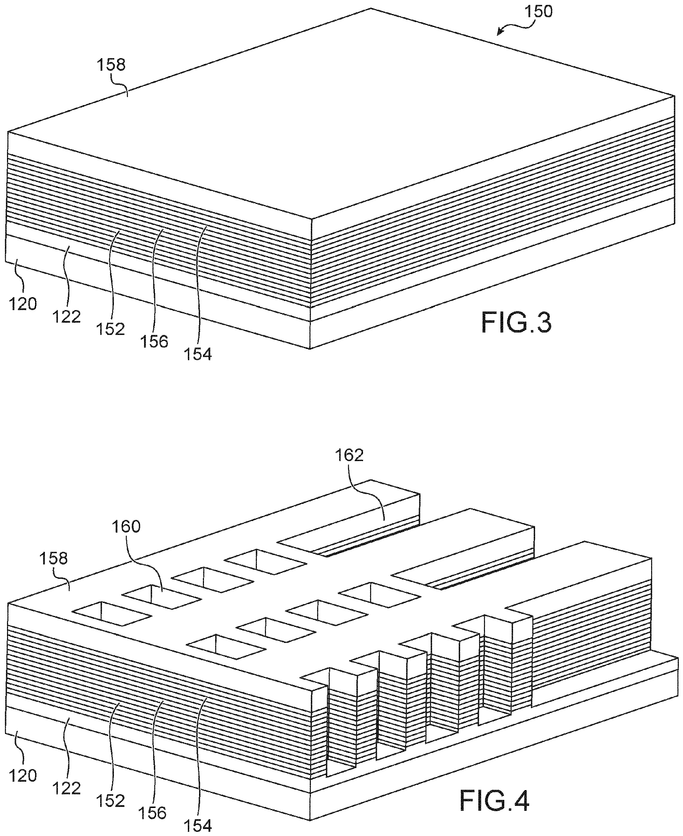

Un procédé de réalisation de la mémoire 100 selon un mode de réalisation particulier est décrit ci-dessous en lien avec les figures 3 à 27.

Un empilement 150 de matériaux est tout d'abord réalisé (voir figure 3). Cet empilement 150 comporte plusieurs premières couches 152 de semi-conducteur destinées à la réalisation des nanofils 114 des transistors d'accès 104 de la mémoire 100. Dans l'exemple de réalisation décrit ici, les premières couches 152 comportent du silicium monocristallin.

Dans l'exemple décrit ici, l'une des premières couches 152 correspond à la couche superficielle du substrat SOI servant de support à l'empilement 150. Ce substrat SOI comporte la couche support 120 et la couche diélectrique enterrée 122 disposée entre la couche support 120 et ladite une des premières couches 152.

L'empilement 150 comporte également une ou plusieurs deuxièmes couches 154 et plusieurs troisièmes couches 156. Chaque deuxième couche 154 est disposée entre deux troisièmes couches 156 et en contact avec ces deux troisièmes couches 156. Chaque troisième couche 156 est en contact avec une des premières couches 152.

Le matériau des deuxièmes couches 154 a pour propriété de pouvoir être gravé sélectivement vis-à-vis du matériau des premières couches 152 et des troisièmes couches 156. Lorsque les premières couches 152 comportent du silicium, cette sélectivité de gravure est par exemple obtenue en réalisant des deuxièmes couches 154 à base de SiGe dont la concentration en Ge est plus forte que celle correspondant à la couche SiGe 156. En outre, le matériau des troisièmes couches 156 a pour propriété de pouvoir être gravé sélectivement vis-à-vis du matériau des premières couches 152. Comme pour les deuxièmes couches 154, cette sélectivité de gravure est par exemple obtenue en réalisant des troisièmes couches 156 à base de SiGe.

En outre, afin qu'il soit possible de graver les deuxièmes couches 154 sélectivement par rapport aux troisièmes couches 156, les taux de germanium dans les semi-conducteurs des deuxièmes et troisièmes couches 154, 156 sont différents. A titre d'exemple, le semi-conducteur des deuxièmes couches 154 peut correspondre à du Si_{0,5}Ge_{0,5}, et le semi-conducteur des troisièmes couches 156 peut correspondre à du Si_{0,3}Ge_{0,7}.

En variante, les premières couches 152 peuvent comporter du silicium polycristallin. Il est également possible que les deuxièmes couches 154 comportent du SiN, et/ou que les troisièmes couches 156 comportent du SiO₂.

Les premières couches 152 autres que celle correspondant à la couche superficielle du substrat SOI, ainsi que les deuxièmes et troisièmes couches 154, 156, sont par exemple réalisées par épitaxie depuis la couche superficielle du substrat SOI.

L'épaisseur de chacune des premières couches 152 est par exemple égale à 15 nm, ou plus généralement comprise entre environ 8 nm et 30 nm. L'épaisseur de chacune des deuxièmes couches 154 est par exemple égale à 10 nm, ou plus généralement comprise entre environ 8 nm et 50 nm. L'épaisseur de chacune des troisièmes couches 156 est par exemple égale à 12 nm, ou plus généralement comprise entre environ 8 nm et 30 nm.

L'empilement 150 est recouvert d'une première couche de masque dur 158. Cette couche 158 comporte par exemple du SiN et a par exemple une épaisseur égale à 80 nm.

Une gravure est mise en oeuvre à travers toute l'épaisseur de l'empilement 150 (voir figure 4). Cette gravure forme des premières cavités 160 destinées à la réalisation des éléments mémoires 102 et des premières et deuxièmes portions électriquement conductrices 116, 118. Dans l'exemple de réalisation décrit ici, ces premières cavités 160 ont, dans un plan parallèle aux plans principaux de chacune des couches 152, 154, 156 (plan parallèle au plan (X,Y)) une section de forme rectangulaire ou circulaire, dont les dimensions sont par exemple comprises entre 30 nm et 300 nm. Les premières cavités 160 sont alignées en formant des lignes et des colonnes.

Cette étape de gravure forme également, à travers toute l'épaisseur de l'empilement 150, des deuxièmes cavités 162, situées en périphérie du coeur de la matrice, destinées à la réalisation des contacts électriques des grilles des transistors d'accès 104. Chaque contact de grille est ensuite relié par une ligne métallique comme représenté sur la Figure 1 (ligne métallique 110, aussi appelée précédemment ligne de mot). Une deuxième cavité 162 est réalisée à une extrémité de chaque ligne de premières cavités 160, afin de former des accès aux grilles des transistors d'accès 104 couplés aux éléments mémoires 102 qui seront réalisés dans les premières cavités 160 de chaque ligne.

Cette étape de gravure est mise en oeuvre en utilisant la première couche de masque dur 158 pour réaliser le masque de gravure. Cette gravure est stoppée sur la couche diélectrique enterrée 122.

Les contacts électriques des grilles des transistors, auxquels les lignes de mot 110 sont destinées à être reliées, peuvent être réalisés au niveau des deuxièmes cavités 162, par exemple en mettant en oeuvre successivement des étapes de lithographie et gravure pour que ces contacts correspondent à des contacts en escalier permettant un accès indépendant à chaque ligne de mot 110.

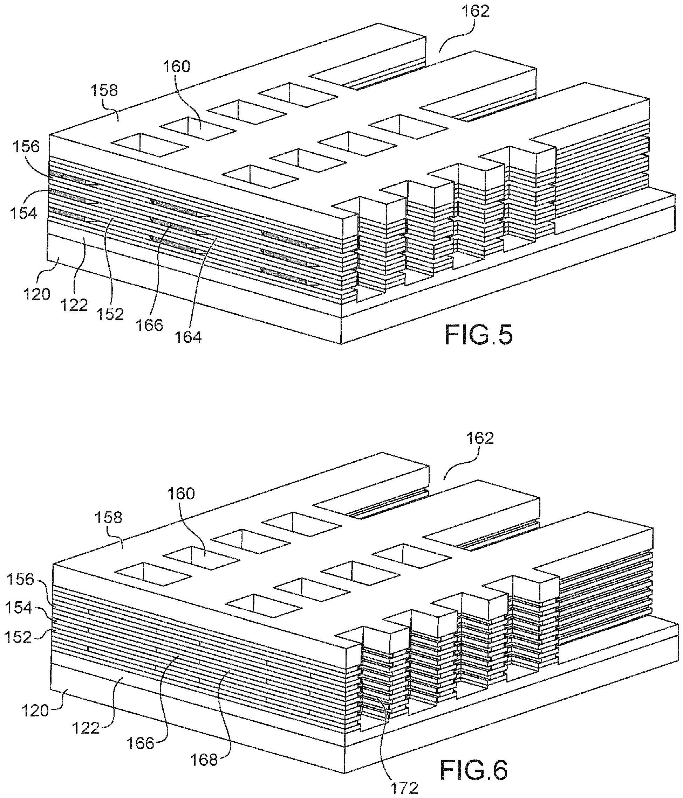

Une autre étape de gravure est ensuite mise en oeuvre afin de supprimer des portions des deuxièmes couches 154 se trouvant entre les premières cavités 160 d'une même ligne (voir figure 5). Sur la figure 5, les espaces formés par cette gravure entre les troisièmes couches 156 portent la référence 164. D'autres portions des deuxièmes couches 154, portant la référence 166, se trouvant entre les lignes de premières cavités 160 sont conservées afin d'assurer le maintien mécanique de l'empilement 150.

Les espaces 164 sont ensuite remplis par un matériau diélectrique, par exemple du SiN. Les portions diélectriques d'isolation déposées dans les espaces 164 portent la référence 168 et sont destinés à isoler électriquement les grilles des transistors d'accès 104 des niveaux différents de la mémoire 100.

Des portions diélectriques destinées à former les espaceurs internes 128 des transistors d'accès sont ensuite réalisées.

Pour cela, une gravure sélective d'une partie des troisièmes couches 156 est mise en oeuvre. Cette gravure est réalisée de manière à obtenir, dans les cavités 160, 162, un retrait du matériau des troisièmes couches 156, par rapport à la surface depuis laquelle le matériau est gravé, sur une profondeur par exemple égale à 20 nm. Sur la figure 6, les creux formés dans les troisièmes couches 156 portent la référence 172.

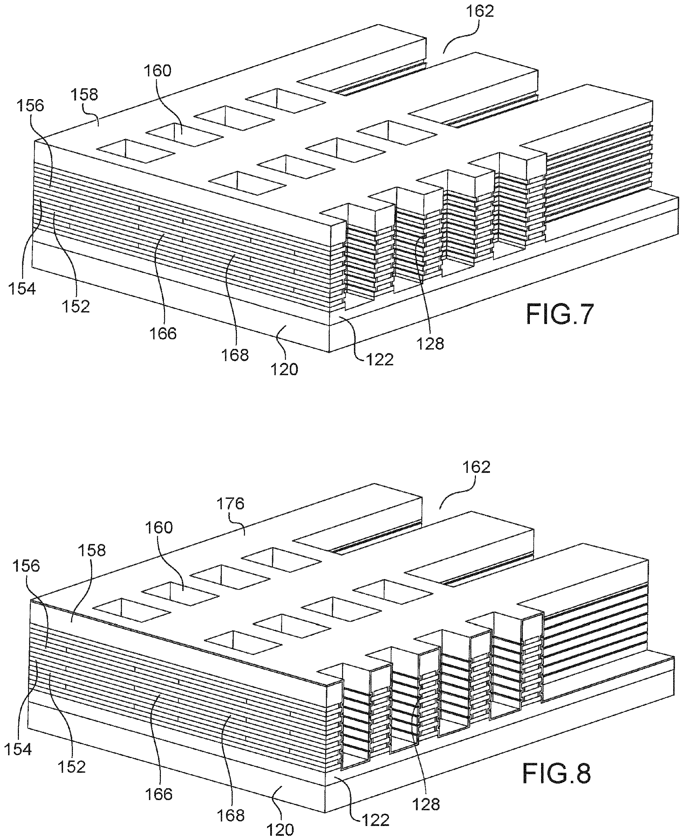

Le ou les matériaux diélectriques destinés à former les espaceurs internes 128 sont ensuite déposés. Dans l'exemple de réalisation décrit ici, une couche de matériau diélectrique est déposée de manière conforme dans les cavités 160, 162 de manière à remplir partiellement les creux 172, et recouvre également la première couche de masque dur 158. Cette couche de matériau diélectrique comporte par exemple du SiN et a par exemple une épaisseur égale à 9 nm. Une gravure humide est ensuite mise en oeuvre pour supprimer les parties de cette couche de matériau diélectrique ne se trouvant pas dans les creux 172 et ne formant pas les espaceurs internes 128, c'est-à-dire les parties de la couche de matériau diélectrique se trouvant contre la première couche de masque dur 158, au fond des cavités 160, 162 et contre les premières couches 152 (voir figure 7).

Une autre couche de matériau diélectrique 176 est déposée de manière conforme dans les cavités 160, 162 et sur la première couche de masque dur 158 (voir figure 8). La deuxième couche de matériau diélectrique 176 comporte par exemple du TEOS tétraéthoxysilane Si(OC₂H₅)₄ et a par exemple une épaisseur égale à 7 nm. Cette deuxième couche de matériau diélectrique 176 est destinée à servir ultérieurement de couche d'arrêt de gravure.

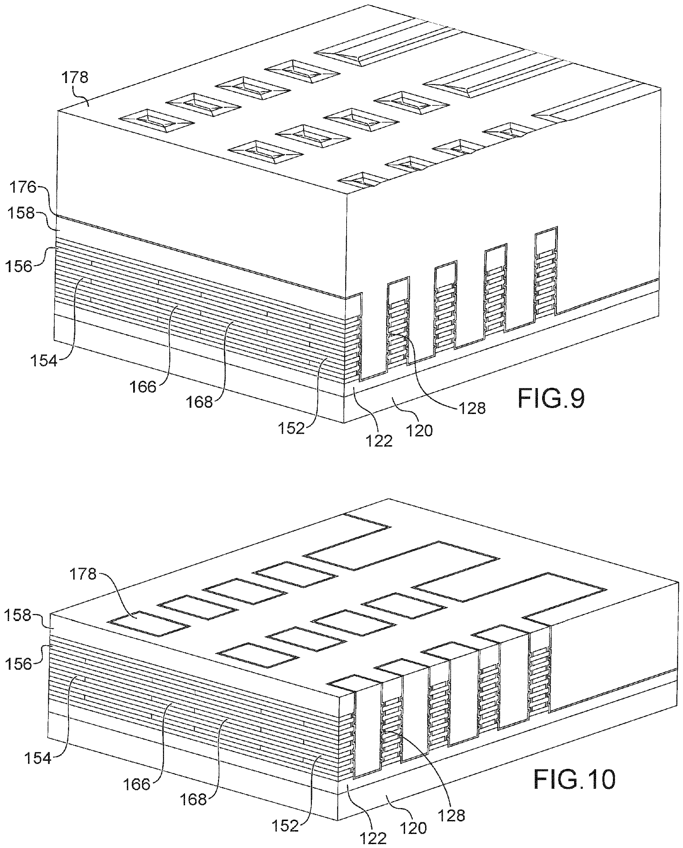

Une couche de matériau sacrificiel 178 pouvant être gravé sélectivement par rapport au matériau de la première couche de masque dur 158 est ensuite déposée de manière à remplir les cavités 160, 162 (voir figure 9). Cette couche de matériau sacrificiel 178 recouvre la deuxième couche de matériau diélectrique 176. La couche de matériau sacrificiel 178 comporte par exemple du polysilicium ou du SoC (« Spin-On Carbon » en anglais), ou tout autre matériau pouvant être gravé sélectivement par rapport au matériau de la première couche de masque dur 158 et au matériau de la deuxième couche de matériau diélectrique 176. L'épaisseur de la couche de matériau sacrificiel 178 est par exemple égale à 380 nm.

Une étape de planarisation mécano-chimique (CMP) est ensuite mise en oeuvre avec arrêt sur la première couche de masque dur 158 afin de supprimer le matériau sacrificiel de la couche 178 localisé sur la première couche de masque dur 158 (voir figure 10). A l'issue de cette étape de CMP, seules les portions de la couche de matériau sacrificiel 178 localisées dans les cavités 160, 162 sont conservées.

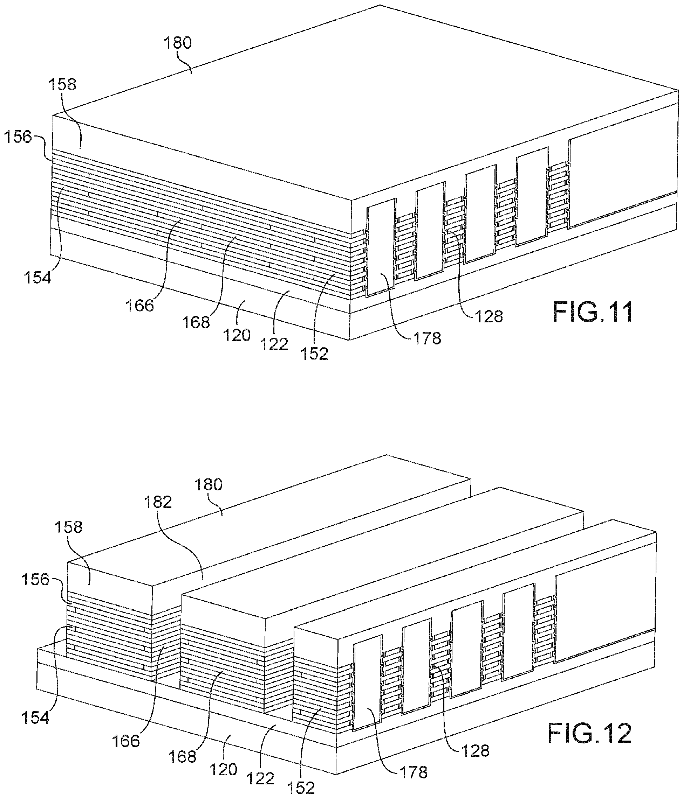

Une deuxième couche de masque dur 180 est déposée sur l'ensemble de la structure réalisée, recouvrant ainsi la première couche de masque dur 158 et les portions restantes de la couche de matériau sacrificiel 178 (voir figure 11). Le matériau de la deuxième couche de masque dur 180 est par exemple similaire à celui de la première couche de masque dur 158, c'est-à-dire ici du SiN. L'épaisseur de la deuxième couche de masque dur 180 est par exemple égale à 10 nm.

Une nouvelle étape de gravure est ensuite mise en oeuvre à travers toute l'épaisseur de l'empilement 150 (voir figure 12). Cette quatrième étape de gravure forme des tranchées 182 séparant et isolant électriquement différentes parties de l'empilement 150 dans chacune desquelles les lignes 3D de la mémoire 100 vont être réalisées, c'est-à-dire les lignes superposées d'éléments mémoires 102 et les lignes superposées des transistors d'accès 104 de la mémoire 100. Chacune de ces parties de l'empilement 150 comporte une ligne de premières cavités 160 au bout de laquelle se trouve une des deuxièmes cavités 162, remplis par le matériau sacrificiel de la couche 178. Cette gravure est par exemple mise en oeuvre en ayant au préalable réalisé le motif des tranchées 182 dans les première et deuxième couches de masque dur 158, 180. Cette gravure est stoppée sur la couche diélectrique enterrée 122.

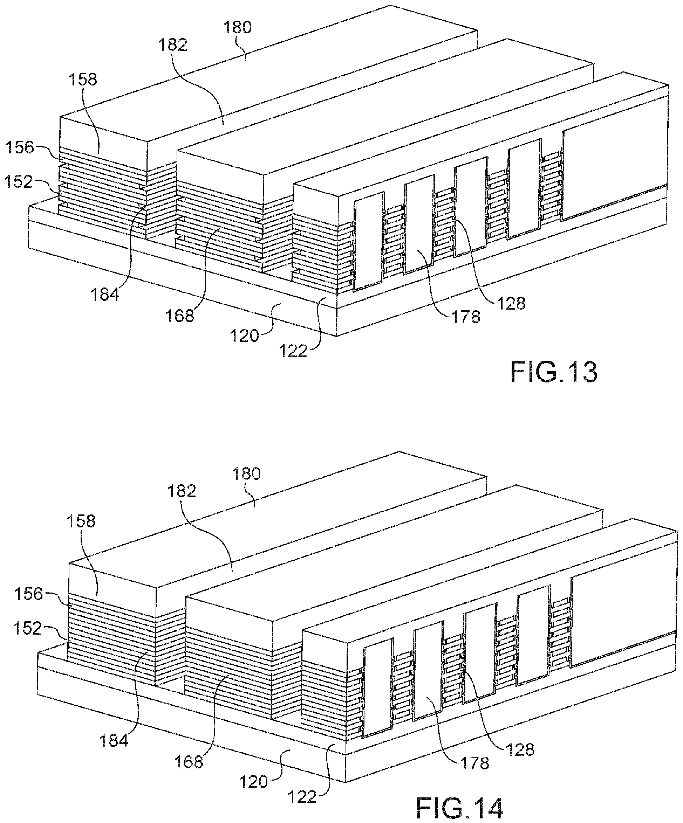

Sur l'exemple de réalisation visible sur la figure 12, les tranchées 182 sont gravées à travers les portions 166 des deuxièmes couches 154, et une partie de ces portions 166 des deuxièmes couches 154 est présente sur les bords des parties restantes de l'empilement 150 qui se trouvent à côté des tranchées 182. Une gravure sélective de parties restantes des portions 166 est alors mise en oeuvre pour les supprimer (voir figure 13). Les creux ou espaces 184 obtenus à l'issue de cette gravure sont ensuite remplis par le dépôt d'un matériau diélectrique similaire à celui des portions diélectriques 168, ici du SiN (voir figure 14). Le matériau diélectrique déposé a par exemple une épaisseur égale à 10 nm (ou plus suivant la profondeur des creux ou espaces 184 à remplir), et les portions de ce matériau se trouvant en dehors des creux ou espaces 184 sont supprimées par autre gravure sélective. Ce matériau diélectrique déposé forme, avec les portions diélectriques 168, les portions 112 destinées à assurer l'isolation électrique entre les grilles des transistors d'accès 104 superposés dans les différents niveaux mémoires.

En variante, il est possible que la précédente étape de gravure formant les tranchées 182 supprime totalement les portions restantes des deuxièmes couches 154 (en réalisant des tranchées 182 plus larges que celles visibles sur la figure 12). Dans ce cas, la gravure formant les creux 184 et le dépôt du matériau diélectrique dans les creux 184 ne sont pas mis en oeuvre, et les parties restantes des portions diélectriques 168 forment les portions diélectriques d'isolation 112.

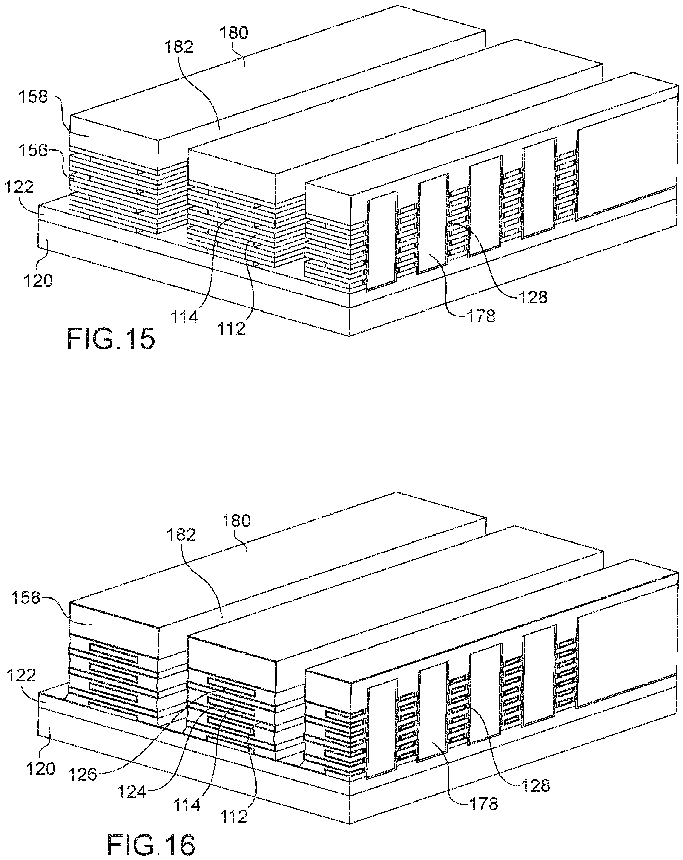

Les portions des premières couches 152 présentes dans chacune des parties de l'empilement 150 isolées par les tranchées 182 sont ensuite partiellement gravées afin que les portions restantes des premières couches 152 forment les nanofils 114 des transistors d'accès 104. Cette gravure correspond par exemple à une gravure sèche ou humide, sélective du semi-conducteur des premières couches 152 vis-à-vis des autres matériaux présents. Cette étape de gravure permet de définir la largeur des nanofils 114 (dimension selon l'axe X sur l'exemple de la figure 15).

Une autre étape de gravure sélective est ensuite mise en oeuvre pour supprimer les portions des troisièmes couches 156 présentes sur et sous les nanofils 114, puis les grilles sont réalisées dans les espaces vides présents tout autour des parties des nanofils 114 destinées à former les canaux des transistors d'accès 104. Ces grilles comportent le ou les matériaux formant le diélectrique de grille 124 disposé contre le semi-conducteur des nanofils 114 et le ou les matériaux conducteurs de grille 126 recouvrant le diélectrique de grille 124. Dans l'exemple de réalisation décrit ici, le diélectrique de grille 124 est formé d'une couche de HfO₂ (ou en variante du SiO₂ ou de I'Al₂O₃ ou tout autre matériau à forte permittivité diélectrique ou « High-k » en anglais) d'épaisseur par exemple égale à 2 nm et le matériau conducteur de grille 126 est formé d'une couche de TiN, ou de toute autre couche métallique pouvant se déposer par CVD ou ALD, d'épaisseur par exemple égale à 10 nm. Les portions de matériau du diélectrique de grille 124 déposées au fond des tranchées 182 sont conservées, et celles du matériau conducteur de grille 126 déposées au fond des tranchées 182 est gravé, par exemple en mettant en oeuvre une gravure humide avec arrêt sur les portions du diélectrique de grille 124 présentes au fond des tranchées 182.

Le dépôt du ou des matériaux conducteurs de grille 126 forment également les lignes de mot 110 qui relient électriquement entre elles les grilles des transistors d'accès 104 localisés dans un même niveau de la mémoire 100 et dans une même ligne 3D de la mémoire 100.

La structure obtenue à ce stade du procédé est représentée sur la figure 16.

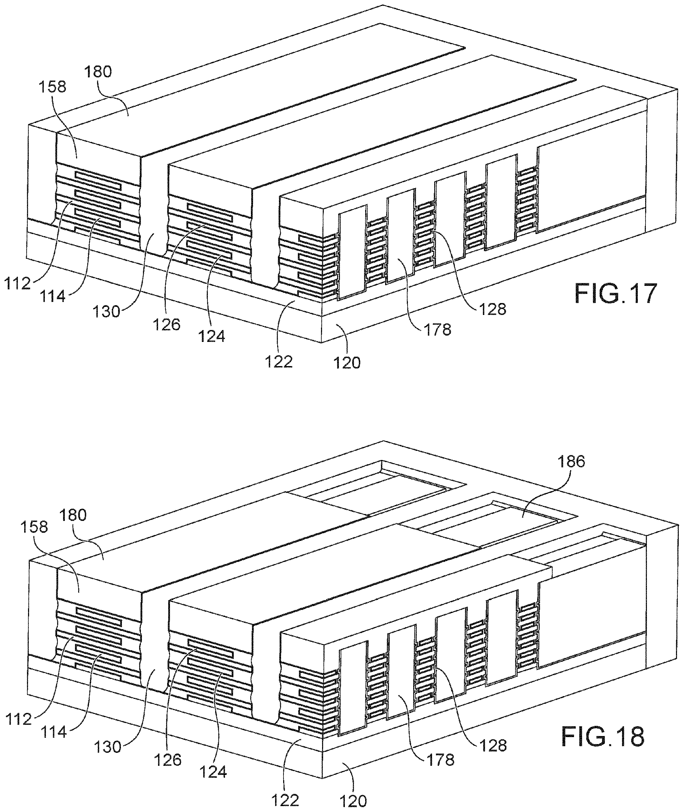

Les tranchées 182 sont ensuite remplies d'un matériau diélectrique, par exemple un oxyde tel que du TEOS ou de l'oxyde HDP, qui subit ensuite une CMP afin que les portions restantes de ce matériau diélectrique forment les éléments diélectriques d'isolation 130 destinés à assurer l'isolation électrique entre les différentes lignes 3D de la mémoire 100 (voir figure 17). La couche de matériau diélectrique déposée a par exemple une épaisseur égale à 500 nm, ou plus généralement une épaisseur supérieure à l'épaisseur minimale requise pour remplir les tranchées 182. La CMP est mise en oeuvre avec arrêt sur la deuxième couche de masque dur 180.

Des parties des première et deuxième couches de masque dur 158, 180 sont ensuite gravées pour former des accès aux portions de la couche de matériau sacrificiel 178 présentes dans les deuxièmes cavités 162. Sur la figure 18, les ouvertures formées à travers les couches de masque dur 158, 180 portent la référence 186. Ces ouvertures 186 sont réalisées par lithographie et gravure.

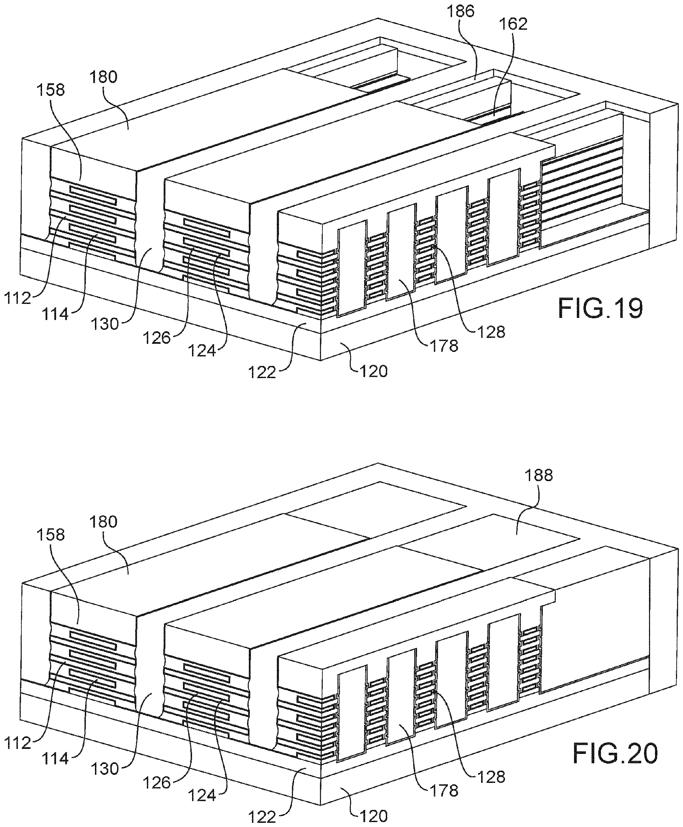

Une gravure, par exemple une gravure sèche ou humide, est mise en oeuvre pour supprimer les portions de la couche de matériau sacrificiel 178 présentes dans les deuxièmes cavités 162 (voir figure 19). Cette gravure libère les deuxièmes cavités 162 qui deviennent accessibles depuis les ouvertures 186. Le matériau de grille présent dans les deuxièmes cavités 162 n'est pas gravé lors de cette étape.

Les deuxièmes cavités 162 sont ensuite remplies par un matériau diélectrique 188 similaire à celui des portions diélectriques 130, qui est déposé, puis planarisé par une CMP arrêtée sur le matériau de la couche du deuxième masque dur 180 (voir figure 20).

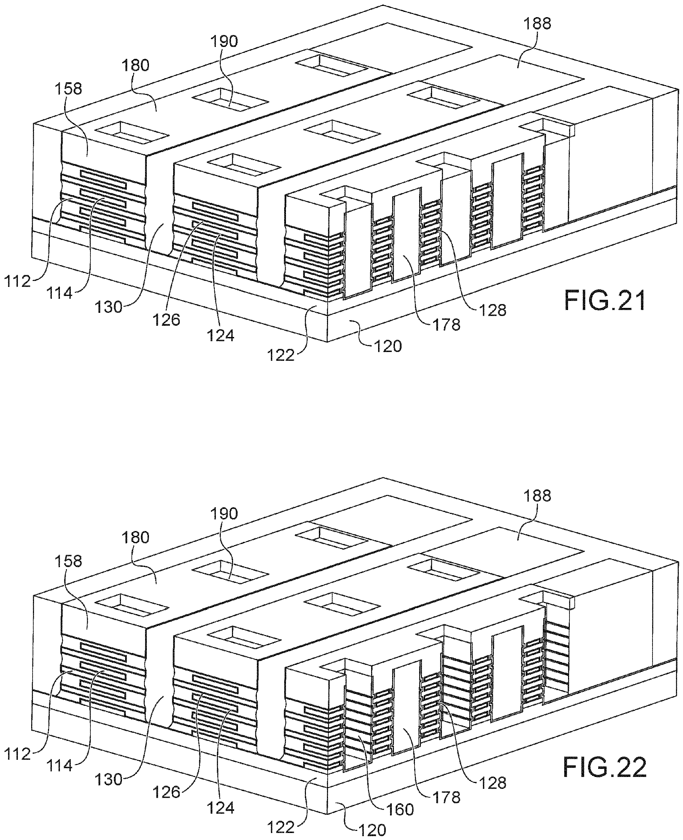

Des ouvertures 190 sont ensuite formées à travers les couches de masque dur 158, 180 afin de former des accès aux portions de la couche de matériau sacrificiel 178 se trouvant dans certaines des premières cavités 160 dans lesquelles les premières portions électriquement conductrices 116 sont destinées à être réalisées (voir figure 21).

Une gravure humide est ensuite mise en oeuvre pour supprimer les portions de la couche de matériau sacrificiel 178 accessibles à travers les ouvertures 190, libérant ainsi les premières cavités 160 dans lesquelles les premières portions électriquement conductrices 116 sont destinées à être réalisées (voir figure 22).

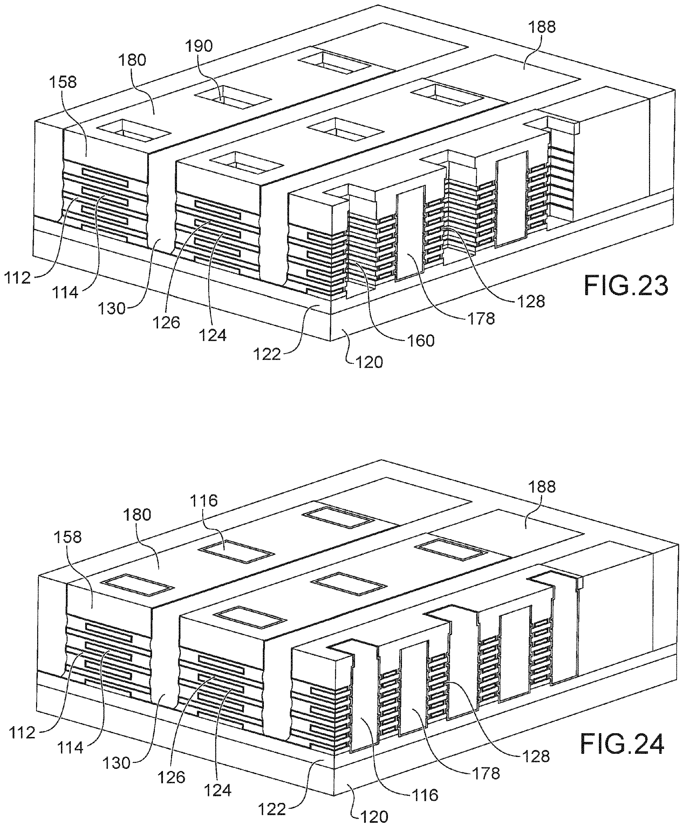

Les parties de la couche diélectrique 176 présentent dans les premières cavités 160 libérées sont ensuite gravées, rendant accessibles notamment les premières extrémités des nanofils 114 depuis ces premières cavités 160 libérées (voir figure 23).

Les premières portions électriquement conductrices 116 sont ensuite réalisées dans les premières cavités 160 libérées et dans les ouvertures 190 (voir figure 24). Dans l'exemple de réalisation décrit ici, les premières portions électriquement conductrices 116 sont formées par des dépôts conformes, par exemple CVD, successifs de plusieurs couches électriquement conductrices, par exemple une première couche de Ti d'épaisseur égale à 5 nm, une deuxième couche de TiN d'épaisseur égale à 5 nm, puis le remplissage de l'espace restant des premiers emplacements 160 libérés par une troisième couche de W. Une CMP est ensuite mise en oeuvre, avec arrêt sur la couche du deuxième masque dur 180, pour supprimer les parties de ces couches déposées sur la couche du deuxième masque dur 180. Dans l'exemple de réalisation décrit ici, les premières portions électriquement conductrices 116 sont destinées à former les électrodes de source des transistors d'accès 104.

De manière optionnelle, préalablement à la réalisation des premières portions électriquement conductrices 116, il est possible de mettre en oeuvre une épitaxie des régions de source et de drain des transistors dans les premières cavités 160.

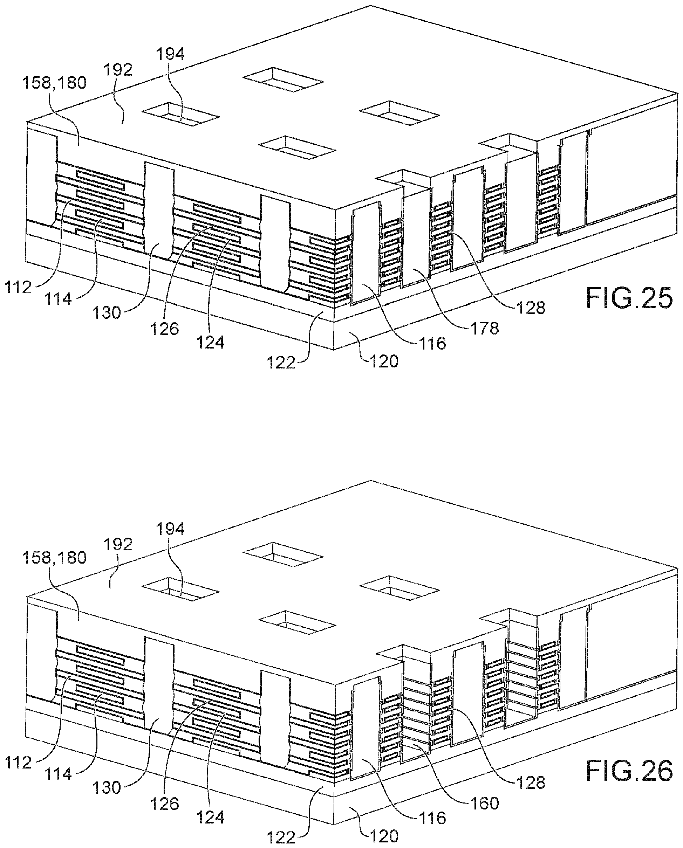

Une nouvelle couche de masque dur 192 est réalisée afin notamment de recouvrir les premières portions électriquement conductrices 116. Des ouvertures 194 sont ensuite formées à travers les couches de masque dur 158, 180, 192 afin de former des accès aux portions de la couche de matériau sacrificiel 178 se trouvant dans les autres premières cavités 160 dans lesquelles les deuxièmes portions électriquement conductrices 118 et les éléments mémoires 102 sont destinés à être réalisés (voir figure 25).

Une gravure humide est ensuite mise en oeuvre pour supprimer les portions de la couche de matériau sacrificiel 178 accessibles à travers les ouvertures 194, libérant ainsi les premières cavités 160 dans lesquelles les deuxièmes portions électriquement conductrices 118 et les éléments mémoires 102 sont destinés à être réalisés (voir figure 26).

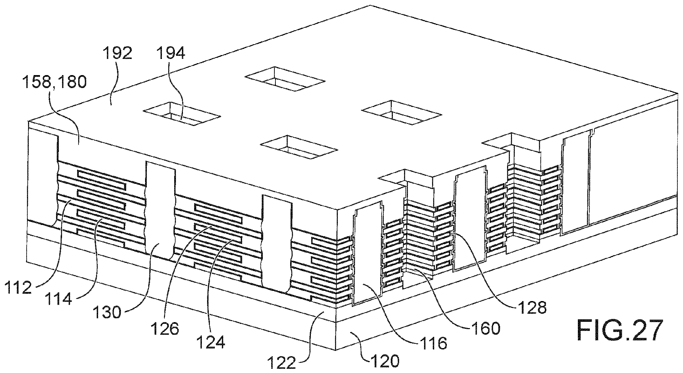

Les parties de la couche diélectrique 176 présentent dans les premières cavités 160 précédemment libérées sont ensuite gravées, rendant accessibles notamment les deuxièmes extrémités des nanofils 114 depuis ces premières cavités 160 libérées (voir figure 27).

Les couches électriquement conductrices 113 destinées à former les deuxièmes électrodes des éléments mémoires 102 et les couches de matériau mémoire 115 sont ensuite déposées de manière conforme dans les premières cavités 160 précédemment libérées. Dans l'exemple de réalisation décrit, la couche de matériau mémoire 115 correspond à une couche de HfO₂ d'épaisseur par exemple égale à 5 nm.

La ou les couches formant les deuxièmes portions électriquement conductrices 118 sont ensuite réalisées dans les premières cavités 160 libérées et dans les ouvertures 194, en recouvrant les couches de matériau mémoire 115. Dans l'exemple de réalisation décrit ici, les deuxièmes portions électriquement conductrices 118 sont formées par des dépôts conformes, par exemple CVD, successifs de plusieurs couches électriquement conductrices, par exemple une première couche de Ti d'épaisseur égale à 5 nm, une deuxième couche de TiN d'épaisseur égale à 5 nm, puis le remplissage de l'espace restant des premières cavités 160 libérées par une troisième couche de W d'épaisseur par exemple égale à 50 nm.

Une CMP est ensuite mise en oeuvre, avec arrêt sur la couche de masque dur 192, pour supprimer les parties de ces couches déposées sur la couche du masque dur 192. Dans l'exemple de réalisation décrit ici, les deuxièmes portions électriquement conductrices 118 sont destinées à former les électrodes de drain des transistors d'accès 104.

Le procédé de réalisation de la mémoire 100 est achevé en réalisant, au sein de niveaux métalliques d'interconnexions réalisés au-dessus de la structure obtenue, des premières et deuxièmes lignes électriquement conductrices 106, 108. La mémoire 100 achevée correspond à celle représentée sur la figure 2.

Dans le procédé de réalisation décrit ci-dessus, les premières portions électriquement conductrices 116 sont réalisées avant les empilements mémoires formant les éléments mémoires 102. En variante, il est possible que les empilements mémoires soient réalisés avant les premières portions électriquement conductrices 116.

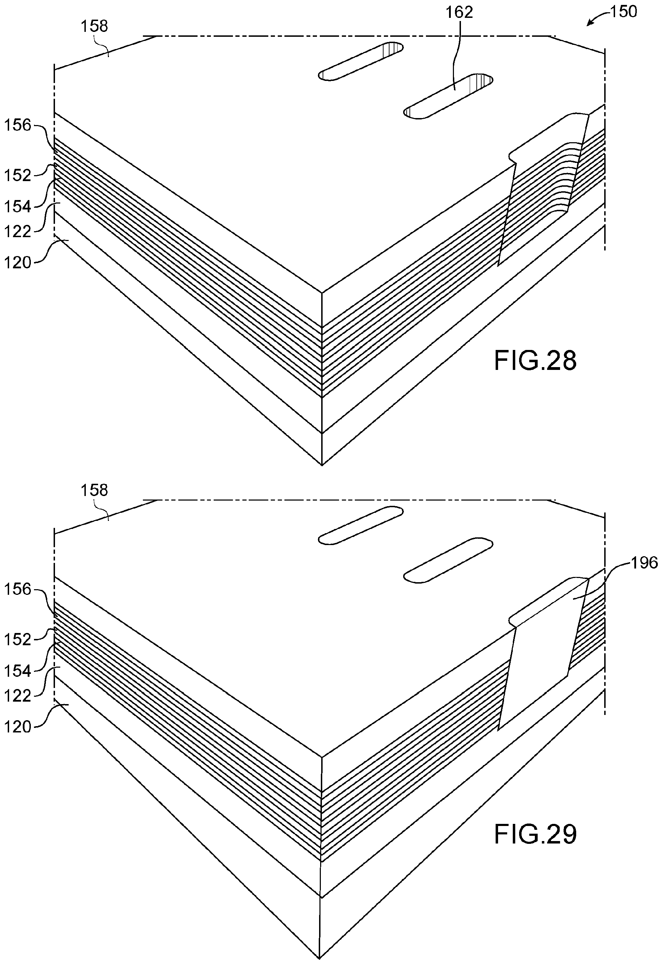

En variante, il est possible que les nanofils 114 formant les canaux des transistors d'accès 104 comportent du semi-conducteur polycristallin, avantageusement du silicium polycristallin. Un exemple de procédé de réalisation d'une mémoire 100 comportant de tels transistors est décrit ci-dessous en lien avec les figures 28 à 37.

L'empilement 150 réalisé comprend les premières couches 152 qui comportent ici du silicium polycristallin, les deuxièmes couches 154 comportant par exemple du SiN, et les troisièmes couches 156 comportant par exemple du SiO₂.

Les deuxièmes cavités 162 sont réalisées dans l'empilement 150. Pour cela, des ouvertures sont formées par lithographie à travers la première couche de masque dur 158, puis une gravure est mise en oeuvre à travers l'empilement 150 jusqu'à atteindre la couche diélectrique enterrée 122 (voir figure 28).

Les deuxièmes cavités 162 sont ensuite remplies par un dépôt d'oxyde HDP (dépôt utilisant un plasma à haute densité), et une CMP avec arrêt sur la première couche de masque dur 158 est mise en oeuvre (voir figure 29, sur laquelle les portions d'oxyde HDP réalisées sont désignées par la référence 196).

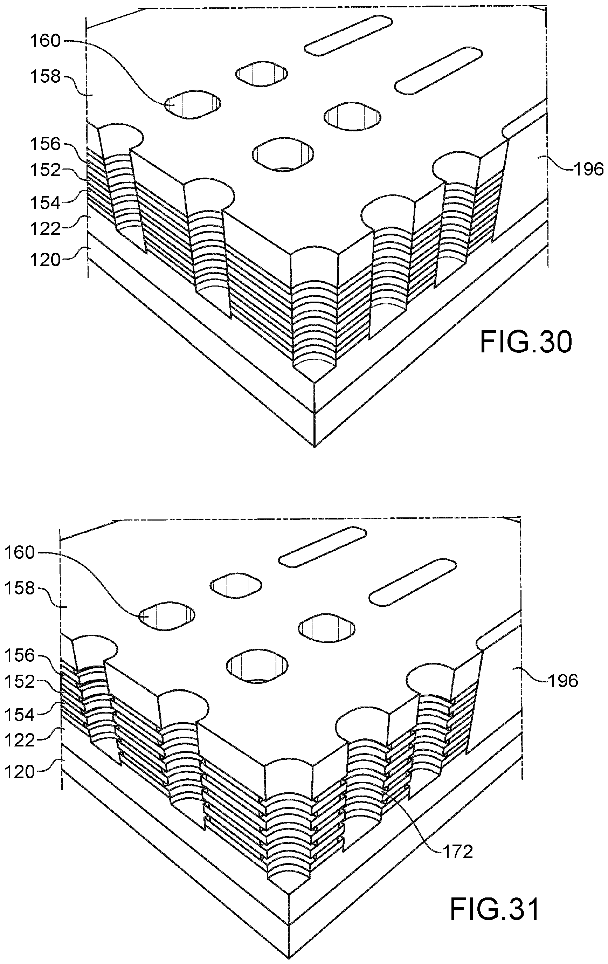

De nouvelles étapes de lithographie et gravure sont mises en oeuvre à travers l'empilement 150, jusqu'à atteindre la couche diélectrique enterrée 122, selon un motif définissant les premières cavités 160 (voir la figure 30).

Une gravure sélective d'une partie des troisièmes couches 156 est mise en oeuvre. Cette gravure est sélective par rapport au silicium polycristallin des premières couches 152 et par rapport au SiN des deuxièmes couches 154. Cette gravure est réalisée de manière à obtenir, dans les cavités 160, un retrait du matériau des troisièmes couches 156, par rapport à la surface depuis laquelle le matériau est gravé, sur une profondeur par exemple égale à 20 nm. Sur la figure 31, les creux formés dans les troisièmes couches 156 portent la référence 172.

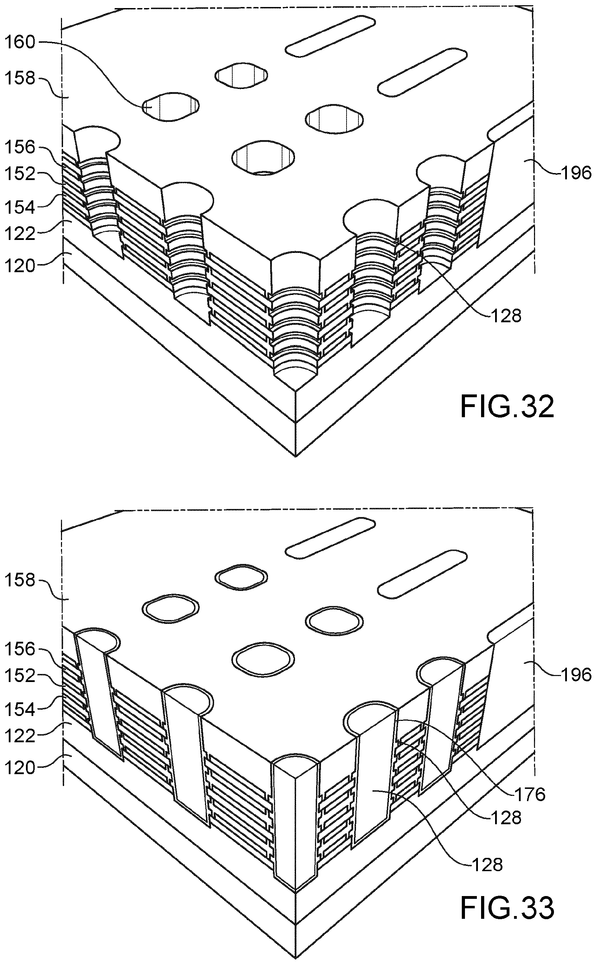

Le ou les matériaux diélectriques destinés à former les espaceurs internes 128 sont ensuite déposés. Comme dans l'exemple de réalisation précédemment décrit, une couche de matériau diélectrique est déposée de manière conforme dans les cavités 160 de manière à remplir partiellement les creux 172, et recouvre également la première couche de masque dur 158. Cette couche de matériau diélectrique comporte par exemple du SiN et a par exemple une épaisseur égale à 9 nm. Une gravure humide est ensuite mise en oeuvre pour supprimer les parties de cette couche de matériau diélectrique ne se trouvant pas dans les creux 172 et ne formant pas les espaceurs internes 128, c'est-à-dire les parties de la couche de matériau diélectrique se trouvant contre la première couche de masque dur 158, au fond des cavités 160, 162 et contre les premières couches 152 (voir figure 32).

La couche de matériau diélectrique 176 est ensuite déposée de manière conforme dans les cavités 160 et sur la première couche de masque dur 158. La deuxième couche de matériau diélectrique 176 comporte par exemple du TEOS et a par exemple une épaisseur égale à 4 nm. La couche de matériau sacrificiel 178 pouvant être gravée sélectivement par rapport au matériau de la première couche de masque dur 158 est ensuite déposée de manière à remplir les cavités 160. Cette couche de matériau sacrificiel 178 recouvre la deuxième couche de matériau diélectrique 176. La couche de matériau sacrificiel 178 comporte par exemple du polysilicium. L'épaisseur de la couche de matériau sacrificiel 178 est par exemple égale à 380 nm.

Une étape de planarisation mécano-chimique (CMP) est ensuite mise en oeuvre avec arrêt sur la première couche de masque dur 158 afin de supprimer les matériaux des couches 176 et 178 localisés sur la première couche de masque dur 158 (voir figure 33). A l'issue de cette étape de CMP, seules les portions des couches de matériaux 176 et 178 localisées dans les cavités 160 sont conservées.

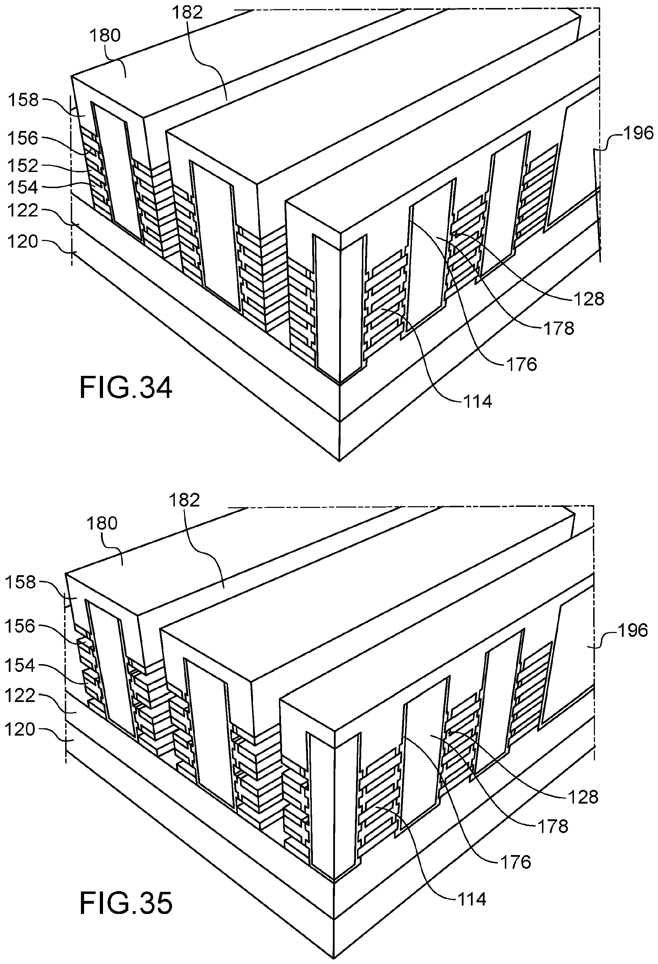

Les lignes de la mémoire 100 sont ensuite isolées électriquement les unes des autres par la mise en oeuvre d'étapes de lithographie et gravure formant les tranchées 182 (voir figure 34).

Les portions des premières couches 152 présentes dans chacune des parties de l'empilement 150 isolées par les tranchées 182 sont ensuite partiellement gravées afin que les portions restantes des premières couches 152 forment les nanofils 114 des transistors d'accès 104. Cette gravure correspond par exemple à une gravure sèche ou humide, sélective vis-à-vis des matériaux des couches 154 et 156 (voir figure 35).

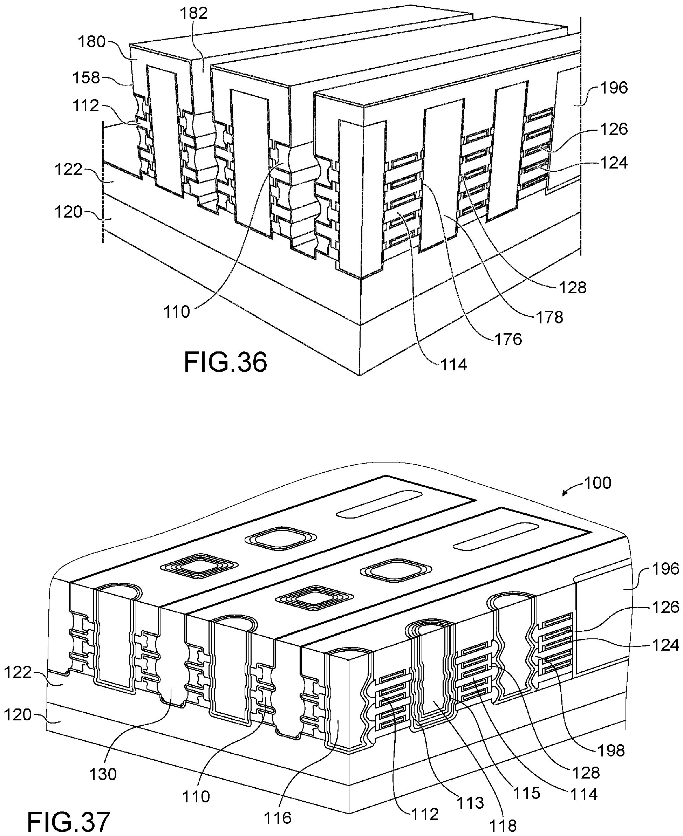

Une autre étape de gravure sélective est ensuite mise en oeuvre pour supprimer les portions des troisièmes couches 156 présentes sur et sous les nanofils 114, puis les grilles sont réalisées dans les espaces vides présents tout autour des parties des nanofils 114 destinées à former les canaux des transistors d'accès 104 (voir figure 36). Ces grilles comportent par exemple du HfO₂ formant le diélectrique de grille 124 disposé contre le semi-conducteur des nanofils 114 et du TiN formant le matériau conducteur de grille 126 recouvrant le diélectrique de grille 124. Comme dans l'exemple de réalisation précédemment décrit, les portions de matériau du diélectrique de grille 124 déposées au fond des tranchées 182 sont conservées, et celles du matériau conducteur de grille 126 déposées au fond des tranchées 182 est gravé par une gravure isotrope avec arrêt sur le matériau du diélectrique de grille 124.

Le dépôt du ou des matériaux conducteurs de grille 126 forment également les lignes de mot 110 qui relient électriquement entre elles les grilles des transistors d'accès 104 localisés dans un même niveau de la mémoire 100 et dans une même ligne 3D de la mémoire 100.

Les portions des couches 176 et 178 présentes dans les premières cavités dans lesquelles les premières portions électriquement conductrices 116 sont destinées à être réalisées sont ensuite gravées, et une étape d'épitaxie de régions de source et de drain est mise en oeuvre pour former une des régions de source et de drain 198 de chaque transistors d'accès 104.

La mémoire 100 est ensuite achevée comme dans l'exemple de réalisation précédemment décrit, en réalisant notamment les premières portions électriquement conductrices 116, les éléments mémoires 102 et les deuxièmes portions électriquement conductrices 118 (voir figure 37).

## Revendications

1. Mémoire (100) comportant une structure en lignes et colonnes sur plusieurs niveaux mémoires superposés, chaque niveau mémoire comprenant au moins une matrice d'éléments mémoires (102) et de transistors d'accès (104) à grille enrobante, chaque transistor d'accès (104) comportant un nanofil semi-conducteur (114) dont au moins une partie est enrobée par une grille (124, 126), chaque grille (124, 126) étant isolée électriquement vis-à-vis des grilles (124, 126) des transistors d'accès (104) des autres niveaux mémoires, la mémoire (100) comprenant :
- des premières portions électriquement conductrices (116), chacune traversant au moins deux niveaux mémoires et étant couplée électriquement à des premières extrémités des nanofils semi-conducteurs (114) de transistors d'accès (104) appartenant à au moins une colonne et une ligne de chacun desdits au moins deux niveaux mémoires ;
- des empilements mémoires, chacun traversant lesdits au moins deux niveaux mémoires et formant des éléments mémoires (102) appartenant à au moins une colonne et une ligne de chacun desdits au moins deux niveaux mémoires, chaque empilement mémoire comprenant au moins une couche de matériau mémoire (115) disposée entre au moins une deuxième portion électriquement conductrice (118) formant une première électrode desdits éléments mémoires (102) et au moins une couche électriquement conductrice (113) formant une deuxième électrode desdits éléments mémoires (102), la couche électriquement conductrice étant disposée contre des deuxièmes extrémités des nanofils semi-conducteurs (114) desdits transistors d'accès (104) ;
- des premières lignes électriquement conductrices (106), chacune étant reliée électriquement aux premières portions électriquement conductrices (116) d'une même colonne de la mémoire (100) ;
- des deuxièmes lignes électriquement conductrices (108), chacune étant reliée électriquement aux deuxièmes portions électriquement conductrices (118) d'une même colonne de la mémoire (100) ;
- des lignes de mot (110) s'étendant chacune dans un même niveau mémoire correspondant à un desdits au moins deux niveaux mémoires en couplant électriquement entre elles les grilles (124, 126) des transistors d'accès (104) d'une même ligne de la mémoire (100) et localisés dans ledit niveau mémoire.

2. Mémoire (100) selon la revendication 1, dans laquelle les nanofils semi-conducteurs (114) des transistors d'accès (104) comportent du silicium polycristallin ou monocristallin, ou de l'oxyde métallique ou au moins un matériau 2D semi-conducteur.

3. Mémoire (100) selon l'une des revendications précédentes, dans laquelle le matériau mémoire correspond à un matériau résistif ou magnéto-résistif ou à changement de phase ou ferroélectrique.

4. Mémoire (100) selon l'une des revendications précédentes, dans laquelle chacune des lignes de mot (110) d'une ligne de la mémoire (100) est isolée électriquement des autres lignes de mot (110) appartenant à ladite ligne de la mémoire (100).

5. Mémoire (100) selon la revendication 4, comportant en outre, dans chaque ligne de la mémoire, des contacts électriques de grille chacun couplé électriquement à une des lignes de mot (110) d'un des niveaux mémoires, localisés à une extrémité de ladite ligne de la mémoire (100) et isolés électriquement les uns vis-à-vis des autres.

6. Mémoire (100) selon l'une des revendications précédentes, dans laquelle chacune des lignes de mot (110) d'une ligne de la mémoire (100) est isolée électriquement des lignes de mot (110) appartenant aux autres lignes de la mémoire (100).

7. Mémoire (100) selon l'une des revendications précédentes, dans laquelle les premières et deuxièmes lignes électriquement conductrices (106, 108) font partie de niveaux métalliques d'interconnexions distincts des niveaux mémoires.

8. Mémoire (100) selon l'une des revendications précédentes, comportant en outre des portions diélectriques d'isolation (112) interposées entre des grilles (124, 126) superposées et disposées dans deux niveaux mémoires voisins.

9. Mémoire (100) selon l'une des revendications précédentes, comportant en outre des éléments diélectriques d'isolation (130) traversant tous les niveaux mémoires et séparant chacun deux lignes voisines de la mémoire (100).

10. Mémoire (100) selon l'une des revendications précédentes, dans laquelle :
- chacune des premières portions électriquement conductrices (116) peut traverser tous les niveaux mémoires et être couplée électriquement aux premières extrémités des nanofils semi-conducteurs (114) de transistors d'accès (104) de chacun des niveaux mémoires ;
- chacun des empilements mémoires traverse tous les niveaux mémoires et forme des éléments mémoires (102) de chacun des niveaux mémoires ;
- les lignes de mot (110) s'étendent dans chacun des niveaux mémoires.

11. Procédé de réalisation d'une mémoire (100) comportant au moins :
- réalisation d'un empilement (150) de premières, deuxièmes et troisièmes couches (152, 154, 156), chaque deuxième couche (154) étant disposée entre deux troisièmes couches (156) et en contact avec ces deux troisièmes couches (156), et chaque troisième couche (156) étant en contact avec une des premières couches (152), les premières couches (152) comportant un matériau semi-conducteur, les deuxièmes couches (154) comportant un matériau pouvant être gravé sélectivement vis-à-vis des matériaux des premières et troisièmes couches (152, 156), et les troisièmes couches (156) comportant un matériau pouvant être gravé sélectivement vis-à-vis des matériaux des premières et deuxièmes couches (152, 154) ;
- gravure de premières cavités (160) à travers au moins une partie de l'épaisseur de l'empilement (150), alignées en formant des lignes et des colonnes ;
- gravure de parties des deuxièmes couches (154) localisées entre les premières cavités (160) d'une même ligne ;
- réalisation de portions diélectriques d'isolation (112) dans des espaces (164) formés par la gravure desdites parties des deuxièmes couches (154), et configurées pour assurer une isolation électrique entre différents niveaux mémoires ;
- gravure de tranchées (182) à travers toute l'épaisseur de l'empilement (150), séparant et isolant des parties de l'empilement (150) comportant chacune une ligne de premières cavités (160) ;
- gravure partielle des premières couches (152) depuis les tranchées (182), telle que des portions restantes des premières couches de semi-conducteur (152) localisées entre les premières cavités (160) forment des nanofils semi-conducteurs (114) ;
- gravure des troisièmes couches (156) de l'empilement (150) ;
- dépôt d'au moins un diélectrique de grille (124) et d'au moins un matériau conducteur de grille (126) dans des espaces formés par la gravure des troisièmes couches (156) de l'empilement (150), formant une grille enrobante autour d'au moins partie de chacun des nanofils semi-conducteurs (114) et des lignes de mot (110) s'étendant chacune dans un même niveau mémoire correspondant à un des niveaux mémoires en couplant électriquement entre elles les grilles (124, 126) d'une même ligne et localisées dans ledit un des niveaux mémoires ;
- dépôt d'un matériau diélectrique (130) dans les tranchées (182) ;
- réalisation de premières portions électriquement conductrices (116) dans une partie des premières cavités (160) telles que chacune traverse au moins deux niveaux mémoires et soit couplée électriquement à des premières extrémités des nanofils semi-conducteurs (114) au niveau d'au moins une face latérale de ladite première portion électriquement conductrice (116) ;
- réalisation d'empilement mémoires dans les autres premières cavités (160), chacun traversant lesdits au moins deux niveaux mémoires et comprenant au moins une couche de matériau mémoire (115) disposée entre au moins une deuxième portion électriquement conductrice (118) et au moins une couche électriquement conductrice (113) disposée contre des deuxièmes extrémités des nanofils semi-conducteurs (114) ;
- réalisation de premières lignes électriquement conductrices (106) telles que chacune soit reliée électriquement aux premières portions électriquement conductrices (116) d'une même colonne de la mémoire (100), et réalisation de deuxièmes lignes électriquement conductrices (108) telles que chacune soit reliée électriquement aux deuxièmes portions électriquement conductrices (118) d'une même colonne de la mémoire (100).

12. Procédé selon la revendication 11, dans lequel :
- les premières couches (152) comportent du silicium,
- les deuxièmes et troisièmes couches (154, 156) comportent du SiGe, et
- le taux de germanium dans le SiGe des deuxièmes couches (154) est différent du taux de germanium dans le SiGe des troisièmes couches (156).

13. Procédé selon l'une des revendications 11 ou 12, comportant en outre, entre la réalisation des portions diélectriques d'isolation (112) et la gravure des tranchées (182), une gravure partielle des troisièmes couches (156) de l'empilement (150) depuis des parois latérales des premières cavités (160), puis une réalisation d'espaceurs diélectriques internes (128) dans des espaces (172) formés par la gravure partielles des troisièmes couches (156).

14. Procédé selon l'une des revendications 11 à 13, comportant en outre, entre la réalisation des portions diélectriques d'isolation (112) et la gravure des tranchées (182), un dépôt d'un matériau sacrificiel (178) dans les premières cavités (160), ce matériau sacrificiel (178) étant supprimé avant la réalisation des premières et deuxièmes portions électriquement conductrices (116, 118).

15. Procédé selon l'une des revendications 11 à 14, dans lequel l'étape de gravure des premières cavités (160) forme également des deuxièmes cavités (162) à travers toute l'épaisseur de l'empilement (150) et chacune localisée à une extrémité d'une ligne de premières cavités (160), et comportant en outre une étape de réalisation de contacts électriques de grille dans les deuxièmes cavités (162), chacun couplé électriquement à une ligne de mot (110) d'un des niveaux mémoires et isolés électriquement les uns vis-à-vis des autres.

## Patentansprüche

1. Speicher (100), der eine Struktur in Zeilen und Spalten auf mehreren übereinanderliegenden Speicherebenen enthält, wobei jede Speicherebene mindestens eine Matrix aus Speicherelementen (102) und Gate-Allround-Zugriffstransistoren (104) umfasst, wobei jeder Zugriffstransistor (104) einen Halbleiter-Nanodraht (114) enthält, von dem mindestens ein Teil durch ein Gate (124, 126) eingebettet ist, wobei jedes Gate (124, 126) von den Gates (124, 126) der Zugriffstransistoren (104) der anderen Speicherebenen elektrisch isoliert ist, wobei der Speicher (100) Folgendes umfasst:
- erste elektrisch leitende Abschnitte (116), die jeweils durch mindestens zwei Speicherebenen verlaufen und elektrisch mit ersten Enden der Halbleiter-Nanodrähte (114) von Zugriffstransistoren (104) gekoppelt sind, die zu mindestens einer Spalte und einer Zeile jeder der mindestens zwei Speicherebenen gehören;
- Speicherstapel, die jeweils durch die mindestens zwei Speicherebenen verlaufen und Speicherelemente (102) bilden, die zu mindestens einer Spalte und einer Zeile von jeder der mindestens zwei Speicherebenen gehören, wobei jeder Speicherstapel mindestens eine Speichermaterialschicht (115) umfasst, die zwischen mindestens einem zweiten elektrisch leitenden Abschnitt (118), der eine erste Elektrode der Speicherelemente (102) bildet, und mindestens einer elektrisch leitenden Schicht (113), die eine zweite Elektrode der Speicherelemente (102) bildet, angeordnet ist, wobei die elektrisch leitende Schicht an zweiten Enden der Halbleiter-Nanodrähte (114) der Zugriffstransistoren (104) angeordnet ist;
- erste elektrisch leitende Leitungen (106), die jeweils elektrisch mit den ersten elektrisch leitenden Abschnitten (116) derselben Spalte des Speichers (100) verbunden sind;
- zweite elektrisch leitende Leitungen (108), die jeweils elektrisch mit den zweiten elektrisch leitenden Abschnitten (118) derselben Spalte des Speichers (100) verbunden sind;
- Wortleitungen (110), die sich jeweils in derselben Speicherebene erstrecken, die einer der mindestens zwei Speicherebenen entspricht, indem sie die Gates (124, 126) der Zugriffstransistoren (104) derselben Zeile des Speichers (100), die sich in der Speicherebene befinden, elektrisch miteinander koppeln.

2. Speicher (100) nach Anspruch 1, wobei die Halbleiter-Nanodrähte (114) der Zugriffstransistoren (104) polykristallines oder monokristallines Silizium oder Metalloxid oder mindestens ein 2D-Halbleitermaterial umfassen.

3. Speicher (100) nach einem der vorhergehenden Ansprüche, wobei das Speichermaterial einem resistiven oder magnetoresistiven oder Phasenwechsel- oder ferroelektrischen Material entspricht.

4. Speicher (100) nach einem der vorhergehenden Ansprüche, wobei jede der Wortleitungen (110) einer Zeile des Speichers (100) von den anderen Wortleitungen (110), die zu dieser Zeile des Speichers (100) gehören, elektrisch isoliert ist.

5. Speicher (100) nach Anspruch 4, der ferner in jeder Zeile des Speichers elektrische Gate-Kontakte enthält, die jeweils elektrisch mit einer der Wortleitungen (110) einer der Speicherebenen verbunden sind, sich an einem Ende der Zeile des Speichers (100) befinden und elektrisch voneinander isoliert sind.

6. Speicher (100) nach einem der vorhergehenden Ansprüche, wobei jede der Wortleitungen (110) einer Zeile des Speichers (100) von den Wortleitungen (110), die zu den anderen Zeilen des Speichers (100) gehören, elektrisch isoliert ist.

7. Speicher (100) nach einem der vorhergehenden Ansprüche, wobei die ersten und zweiten elektrisch leitenden Leitung (106, 108) Teil von metallischen Zwischenverbindungsebenen sind, die sich von den Speicherebenen unterscheiden.

8. Speicher (100) nach einem der vorhergehenden Ansprüche, der ferner dielektrische Isolationsabschnitte (112) enthält, die zwischen übereinanderliegenden Gates (124, 126) eingefügt und in zwei benachbarten Speicherebenen angeordnet sind.

9. Speicher (100) nach einem der vorhergehenden Ansprüche, der ferner dielektrische Isolationselemente (130) enthält, die durch alle Speicherebenen verlaufen und jeweils zwei benachbarte Zeilen des Speichers (100) trennen.

10. Speicher (100) nach einem der vorhergehenden Ansprüche, wobei:
- jeder der ersten elektrisch leitenden Abschnitte (116) durch alle Speicherebenen verlaufen und elektrisch mit den ersten Enden der Halbleiter-Nanodrähte (114) von Zugriffstransistoren (104) jeder der Speicherebenen gekoppelt sein kann;
- jeder der Speicherstapel durch alle Speicherebenen verläuft und Speicherelemente (102) jeder der Speicherebenen bildet;
- die Wortleitungen (110) sich in jeder der Speicherebenen erstrecken.

11. Verfahren zum Herstellen eines Speichers (100), das mindestens Folgendes umfasst:
- Herstellen eines Stapels (150) aus ersten, zweiten und dritten Schichten (152, 154, 156), wobei jede zweite Schicht (154) zwischen zwei dritten Schichten (156) angeordnet ist und mit diesen beiden dritten Schichten (156) in Kontakt steht und jede dritte Schicht (156) mit einer der ersten Schichten (152) in Kontakt steht, wobei die ersten Schichten (152) ein Halbleitermaterial enthalten, die zweiten Schichten (154) ein Material enthalten, das selektiv in Bezug auf die Materialien der ersten und dritten Schichten (152, 156) geätzt werden kann, und die dritten Schichten (156) ein Material enthalten, das selektiv im Verhältnis zu den Materialien der ersten und zweiten Schichten (152, 154) geätzt werden kann;
- Ätzen von ersten Hohlräumen (160) durch mindestens einen Teil der Dicke des Stapels (150), die unter Bildung von Zeilen und Spalten ausgerichtet sind;
- Ätzen von Teilen der zweiten Schichten (154), die sich zwischen den ersten Hohlräumen (160) derselben Zeile befinden;
- Herstellen von dielektrischen Isolationsabschnitten (112) in Räumen (164), die durch das Ätzen der Teile der zweiten Schichten (154) gebildet und so konfiguriert sind, dass sie eine elektrische Isolierung zwischen verschiedenen Speicherebenen gewährleisten;
- Ätzen von Gräben (182) durch die gesamte Dicke des Stapels (150), die Teile des Stapels (150) trennen und isolieren, die jeweils eine Reihe von ersten Hohlräumen (160) enthalten;
- teilweises Ätzen der ersten Schichten (152) aus den Gräben (182), so dass verbleibende Abschnitte der ersten Halbleiterschichten (152), die sich zwischen den ersten Hohlräumen (160) befinden, Halbleiter-Nanodrähte (114) bilden;
- Ätzen der dritten Schichten (156) des Stapels (150);
- Abscheiden von mindestens einem Gate-Dielektrikum (124) und mindestens einem Gate-Leitmaterial (126) in den Räumen, die durch das Ätzen der dritten Schichten (156) des Stapels (150) gebildet werden, wodurch ein Allround-Gate um mindestens einen Teil jedes der Halbleiter-Nanodrähte (114) und der Wortleitungen (110) gebildet wird, die sich jeweils in derselben Speicherebene erstrecken, die einer der Speicherebenen entspricht, indem sie die Gates (124,126) derselben Leitung elektrisch miteinander koppeln und sich in der einen der Speicherebenen befinden;
- Abscheiden eines dielektrischen Materials (130) in den Gräben (182);
- Herstellen von ersten elektrisch leitenden Abschnitten (116) in einem Teil der ersten Hohlräume (160), so dass jeder durch mindestens zwei Speicherebenen verläuft und elektrisch mit den ersten Enden der Halbleiter-Nanodrähte (114) auf Höhe mindestens einer Seitenfläche des ersten elektrisch leitenden Abschnitts (116) gekoppelt ist;
- Herstellen eines Speicherstapels in den anderen ersten Hohlräumen (160), die jeweils durch die mindestens zwei Speicherebenen verlaufen und mindestens eine Schicht aus Speichermaterial (115) umfassen, die zwischen mindestens einem zweiten elektrisch leitenden Abschnitt (118) und mindestens einer elektrisch leitenden Schicht (113) angeordnet ist, die gegen zweite Enden der Halbleiter-Nanodrähte (114) angeordnet ist;
- Herstellen ersten elektrisch leitenden Leitungen (106), so dass jede mit den ersten elektrisch leitenden Abschnitten (116) derselben Spalte des Speichers (100) elektrisch verbunden ist, und Herstellen von zweiten elektrisch leitenden Leitungen (108), so dass jede mit den zweiten elektrisch leitenden Abschnitten (118) derselben Spalte des Speichers (100) elektrisch verbunden ist.

12. Verfahren nach Anspruch 11, wobei:
- die ersten Schichten (152) Silizium enthalten,
- die zweiten und dritten Schichten (154, 156) SiGe enthalten, und
- der Germaniumgehalt im SiGe der zweiten Schichten (154) von dem Germaniumgehalt im SiGe der dritten Schichten (156) verschieden ist.

13. Verfahren nach einem der Ansprüche 11 oder 12, das ferner zwischen dem Herstellen der dielektrischen Isolationsabschnitte (112) und dem Ätzen der Gräben (182) ein teilweises Ätzen der dritten Schichten (156) des Stapels (150) aus den Seitenwänden der ersten Hohlräume (160) und dann ein Herstellen von inneren dielektrischen Abstandshaltern (128) in Räumen (172), die durch das teilweise Ätzen der dritten Schichten (156) gebildet werden, umfasst.

14. Verfahren nach einem der Ansprüche 11 bis 13, das ferner zwischen dem Herstellen der dielektrischen Isolationsabschnitte (112) und dem Ätzen der Gräben (182) ein Abscheiden eines Opfermaterials (178) in den ersten Hohlräumen (160) umfasst, wobei dieses Opfermaterial (178) vor dem Herstellen der ersten und zweiten elektrisch leitenden Abschnitte (116, 118) unterdrückt wird.

15. Verfahren nach einem der Ansprüche 11 bis 14, wobei der Schritt des Ätzens der ersten Hohlräume (160) auch zweite Hohlräume (162) über die gesamte Dicke des Stapels (150) bildet, die sich jeweils an einem Ende einer Reihe erster Hohlräume (160) befinden, und ferner umfassend einen Schritt des Herstellens von elektrischen Gate-Kontakten in den zweiten Hohlräumen (162), die jeweils mit einer Wortleitung (110) einer der Speicherebenen elektrisch gekoppelt und voneinander elektrisch isoliert sind.

## Claims

1. A memory (100) including a structure in lines and columns over several superimposed memory levels, each memory level comprising at least one array of memory elements (102) and gate-all-around access transistors (104), each access transistor (104) including a semiconductor nanowire (114) at least one portion of which is embedded by a gate (124, 126), each gate (124, 126) being electrically insulated from the gates (124, 126) of the access transistors (104) of the other memory levels, the memory (100) comprising:
- first electrically-conductive portions (116), each crossing at least two memory levels and being electrically coupled to first ends of the semiconductor nanowires (114) of access transistors (104) belonging to at least one column and one line of each of said at least two memory levels;
- memory stacks, each crossing said at least two memory levels and forming memory elements (102) belonging to at least one column and one line of each of said at least two memory levels, each memory stack comprising at least one memory material layer (115) disposed between at least one second electrically-conductive portion (118) forming a first electrode of said memory elements (102) and at least one electrically-conductive layer (113) forming a second electrode of said memory elements (102), the electrically-conductive layer being disposed against second ends of the semiconductor nanowires (114) of said access transistors (104);
- first electrically-conductive lines (106), each being electrically connected to the first electrically-conductive portions (116) of the same column of the memory (100);
- second electrically-conductive lines (108), each being electrically connected to the second electrically-conductive portions (118) of the same column of the memory (100);
- word lines (110) each extending in the same memory level corresponding to one of said at least two memory levels while electrically coupling together the gates (124, 126) of the access transistors (104) of the same line of the memory (100) and located in said memory level.

2. The memory (100) according to claim 1, wherein the semiconductor nanowires (114) of the access transistors (104) include polycrystalline or monocrystalline silicon or metal oxide or at least one semiconductor 2D material.

3. The memory (100) according to one of the preceding claims, wherein the memory material corresponds to a resistive or magnetoresistive or phase-change or ferroelectric material.

4. The memory (100) according to one of the preceding claims, wherein each of the word lines (110) of a memory line (100) is electrically insulated from the other word lines (110) belonging to said line of the memory (100).

5. The memory (100) according to claim 4, further including, in each line of the memory, gate electrical contacts each electrically coupled to one of the word lines (110) of one of the memory levels, located at one end of said line of the memory (100) and electrically insulated from each other.

6. The memory (100) according to one of the preceding claims, wherein each of the word lines (110) of one line of the memory (100) is electrically insulated from the word lines (110) belonging to the other lines of the memory (100).

7. The memory (100) according to one of the preceding claims, wherein the first and second electrically-conductive lines (106, 108) belong to interconnection metallic levels distinct from the memory levels.

8. The memory (100) according to one of the preceding claims, further including insulation dielectric portions (112) interposed between superimposed gates (124, 126) and disposed in two neighbouring memory levels.

9. The memory (100) according to one of the preceding claims, further including insulation dielectric elements (130) crossing all memory levels and each separating two neighbouring lines of the memory (100).

10. The memory (100) according to one of the preceding claims, wherein:
- each of the first electrically-conductive portions (116) could cross all memory levels and be electrically coupled to the first ends of the semiconductor nanowires (114) of access transistors (104) of each of the memory levels;
- each of the memory stacks crosses all memory levels and forms memory elements (102) of each of the memory levels;
- the word lines (110) extend in each of the memory levels.

11. A method for making a memory (100) including at least:
- making of a stack (150) of first, second and third layers (152, 154, 156), each second layer (154) being disposed between two third layers (156) and in contact with these two third layers (156), and each third layer (156) being in contact with one of the first layers (152), the first layers (152) including a semiconductor material, the second layers (154) including a material that could be etched selectively with regards to the materials of the first and third layers (152, 156), and the third layers (156) including a material that could be etched selectively with regards to the materials of the first and second layers (152, 154);
- etching of first cavities (160) through at least one portion of the thickness of the stack (150), aligned while forming lines and columns;
- etching of portions of the second layers (154) located between the first cavities (160) of the same line;
- making of insulation dielectric portions (112) in spaces (164) formed by etching of said portions of the second layers (154), and configured to ensure an electrical insulation between different memory levels;
- etching of wafers (182) throughout the entire thickness of the stack (150), separating and insulating portions of the stack (150) each including a line of first cavities (160);
- partial etching of the first layers (152) starting from the wafers (182), such that remaining portions of the first semiconductor layers (152) located between the first cavities (160) form semiconductor nanowires (114);
- etching of the third layers (156) of the stack (150);
- deposition of at least one gate dielectric (124) and at least one gate conductive material (126) in spaces formed by etching of the third layers (156) of the stack (150), forming an all-around gate around at least one portion of each of the semiconductor nanowires (114) and of the word lines (110) each extending in the same memory level corresponding to one of the memory levels while electrically coupling together the gates (124, 126) of the same lien and located in said one of the memory levels;
- deposition of a dielectric material (130) in the wafers (182);
- making of first electrically-conductive portions (116) in one portion of the first cavities (160) such that each crosses at least two memory levels and is electrically coupled to first ends of the semiconductor nanowires (114) at least at one lateral face of said first electrically-conductive portion (116);
- making of a memory stack in the other first cavities (160), each crossing said at least two memory levels and comprising at least one memory material layer (115) disposed between at least one second electrically-conductive portion (118) and at least one electrically-conductive layer (113) disposed against second ends of the semiconductor nanowires (114);
- making of first electrically-conductive lines (106) such that each is electrically connected to the first electrically-conductive portions (116) of the same column of the memory (100), and making of second electrically-conductive lines (108) such that each is electrically connected to the second electrically-conductive portions (118) of the same column of the memory (100).

12. The method according to claim 11, wherein:
- the first layers (152) include silicon,
- the second and third layers (154, 156) include SiGe, and
- the germanium content in the SiGe of the second layers (154) is different from the germanium content in the SiGe of the third layers (156).

13. The method according to one of claims 11 or 12, further including, between making of the insulation dielectric portions (112) and etching of the wafers (182), a partial etching of the third layers (156) of the stack (150) starting from the lateral walls of the first cavities (160), then making of inner dielectric spacers (128) in spaces (172) formed by the partial etching of the third layers (156).

14. The method according to one of claims 11 to 13, further including, between making of the insulation dielectric portions (112) and etching of the wafers (182), a deposition of a sacrificial material (178) in the first cavities (160), this sacrificial material (178) being suppressed before making of the first and second electrically-conductive portions (116, 118).

15. The method according to one of claims 11 to 14, wherein the step of etching the first cavities (160) also forms second cavities (162) throughout the entire thickness of the stack (150) and each located at one end of a line of first cavities (160), and further including a step of making gate electrical contacts in the second cavities (162), each electrically coupled to a word line (110) of one of the memory levels and electrically insulated from each other.
